# EUROPEAN PATENT APPLICATION

(11) **EP 4 459 668 A1**
(43) Date of publication of application: **06.11.2024**
(21) Application number: 22914474.6
(22) Date of filing: 22.12.2022
(51) Int. Cl.: H01L 21/67, G05B 19/418

(54) **SEMICONDUCTOR PROCESS APPARATUS SCHEDULING CONTROL METHOD AND SEMICONDUCTOR PROCESS APPARATUS**

(30) Priority: 30.12.2021 CN 202111665533
(71) Applicant: Xi'An Naura Microelectronics Equipment Co., Ltd., Xi'an, Shaanxi 710075 (CN); Beijing NAURA Microelectronics Equipment Co., Ltd., Beijing 100176 (CN)
(72) Inventor: ZHAO, Junxiang, Beijing 100176 (CN)
(74) Representative: Cohausz & Florack
(86) International application number: PCT/CN2022/140947
(87) International publication number: WO 2023/125220

(57) **Abstract**

Embodiments of the present disclosure provide a scheduling control method for a semiconductor process apparatus and a semiconductor process apparatus, the semiconductor process apparatus includes a plurality of modules that are configured with corresponding specified tasks, and the method includes: for the plurality of modules, acquiring module information corresponding to the modules one module by one module, and determining whether the specified tasks corresponding to the modules are executable based on preset rules and the module information corresponding to the modules, with the module information including module state information and material existence information and the preset rules including rules for determining whether the modules execute the corresponding specified tasks; and if it is determined that the specified tasks corresponding to the modules are executable, controlling the modules to execute the corresponding specified tasks. According to the embodiments of the present disclosure, an influence of inaccuracy of manually set parameters can be reduced, the tasks executable by the modules can be quickly determined, idle time of each module for waiting for the tasks can be reduced, utilization of each module can be improved, and equipment production capacity can be increased.

## Description

### TECHNICAL FIELD

The present disclosure relates to the field of semiconductor manufacturing technology, and in particular, to a scheduling control method for a semiconductor process apparatus and a semiconductor process apparatus.

### BACKGROUND

In a processing process of a semiconductor process apparatus, a material is processed by modules of the semiconductor process apparatus along a set material path.

When a plurality of materials need to be processed, there is a demand for simultaneously scheduling the plurality of materials at the same time. With existing material scheduling methods, firstly, an initial state of each module and execution time of an action task of each module, which are manually set, need to be acquired during initialization; state information and material information of all the modules of the semiconductor process apparatus are acquired before transfer paths are calculated, and the transfer paths of all the materials are calculated according to the state information and the material information of all the modules and the execution time of the action task of each module; and then the modules are controlled to execute the action tasks according to the transfer paths of all the materials.

The existing material scheduling methods generally adopt a scheduling algorithm based on a search tree or a Petri network, and the algorithm is high in complexity; and the execution time of the action task of each module needs to be manually set, which not only consumes manpower but also causes errors. When the number of the materials is large, it takes a long time to calculate the transfer paths of all the materials; and if each module is already in an idle state and waits for executing the action task while the transfer paths are being calculated, equipment production capacity is affected.

In view of the above problem, embodiments of the present disclosure provide a scheduling control method for a semiconductor process apparatus and a semiconductor process apparatus, so as to overcome or at least partially solve the above problem.

In order to solve the above problem, an embodiment of the present disclosure discloses a scheduling control method for a semiconductor process apparatus, the semiconductor process apparatus includes a plurality of modules that are configured with corresponding specified tasks, and the method includes:
for the plurality of modules, acquiring module information corresponding to the modules one module by one module, and determining whether the specified tasks corresponding to the modules are executable based on preset rules and the module information corresponding to the modules; the module information includes module state information and material existence information; and the preset rules include rules for determining whether the modules execute the corresponding specified tasks; and
if it is determined that the specified tasks corresponding to the modules are executable, controlling the modules to execute the corresponding specified tasks.

Optionally, the plurality of modules include: a process chamber, a pre-pumping chamber, a cooling module, a manipulator, and an alignment module; and
the preset rules include: a judgment rule for determining whether the process chamber executes a process task; judgment rules for determining whether the pre-pumping chamber executes a vent task and a pump task; a judgment rule for determining whether the cooling module executes a process task; a judgment rule for determining whether the alignment module executes an alignment task; and judgment rules for determining whether the manipulator executes a pick-up task, a placement task, and an exchange task.

Optionally, determining whether the specified tasks corresponding to the modules are executable based on the preset rules and the module information corresponding to the modules includes:
based on the judgment rule for determining whether the process chamber executes the process task, if it is determined, according to the module information corresponding to the process chamber, that the process chamber is in an idle state, a material exists in the process chamber, and the material is not subjected to the process task in the process chamber, determining that the process chamber can execute the process task.

Optionally, determining whether the specified tasks corresponding to the modules are executable based on the preset rules and the module information corresponding to the modules includes:
based on the judgment rule for determining whether the cooling module executes the process task, if it is determined, according to the module information corresponding to the cooling module, that the cooling module is in an idle state, a material exists in the cooling module, and the material is not subjected to the process task in the cooling module, determining that the cooling module can execute the process task.

Optionally, the manipulator includes an atmospheric manipulator, and determining whether the specified tasks corresponding to the modules are executable based on the preset rules and the module information corresponding to the modules includes:
based on a judgment rule for determining whether the pre-pumping chamber executes the vent task, if it is determined, according to the module information corresponding to the pre-pumping chamber, that there is a pre-pumping chamber which is in an idle state and is not in an atmospheric environment, determining whether a material exists in the pre-pumping chamber;
if the material exists in the pre-pumping chamber and a next step for the material is the atmospheric manipulator picking up the material and placing the material into an atmospheric end, determining that the pre-pumping chamber can execute the vent task; and
if there is no material in the pre-pumping chamber and a number of materials to be placed by the atmospheric manipulator into pre-pumping chambers is less than a number of pre-pumping chambers that are in the atmospheric environment, determining that the pre-pumping chamber can execute the vent task.

Optionally, the manipulator includes a vacuum manipulator, and determining whether the specified tasks corresponding to the modules are executable based on the preset rules and the module information corresponding to the modules includes:
based on a judgment rule for determining whether the pre-pumping chamber executes the pump task, if it is determined, according to the module information corresponding to the pre-pumping chamber, that there is a pre-pumping chamber which is in an idle state and is not in a vacuum environment, determining whether a material exists in the pre-pumping chamber;
if the material exists in the pre-pumping chamber and a next step for the material is the vacuum manipulator picking up the material and placing the material into a vacuum end, determining that the pre-pumping chamber can execute the pump task; and
if there is no material in the pre-pumping chamber and a number of materials to be placed by the vacuum manipulator into pre-pumping chambers is less than a number of pre-pumping chambers that are in the vacuum environment, determining that the pre-pumping chamber can execute the pump task.

Optionally, determining whether the specified tasks corresponding to the modules are executable based on the preset rules and the module information corresponding to the modules includes:
based on the judgment rule for determining whether the alignment module executes the alignment task, if it is determined, according to the module information corresponding to the alignment module, that the alignment module is in an idle state and materials not subjected to the alignment task exist in the alignment module, determining that the alignment module can execute the alignment task.

Optionally, determining whether the specified tasks corresponding to the modules are executable based on the preset rules and the module information corresponding to the modules includes:
in a case where the preset rules further include a material first-in first-out rule, based on a judgment rule for determining whether the manipulator executes the placement task, if it is determined, according to the module information corresponding to the manipulator, that the manipulator is in an idle state and materials exist on the manipulator, grouping the materials on the manipulator according to the modules where the materials need to arrive at next steps;
sequentially determining material IDs of the materials in each group, and determining a material with a minimum material ID in each group; and the material IDs are set for the materials based on the material first-in first-out rule;
if a module where a material with a minimum material ID in a group needs to arrive at a next step is in an idle state and has an idle slot, determining that the manipulator can execute the placement task for the material with the minimum material ID in the group; and
if there is no material to be subjected to the placement task in any group, determining that the manipulator is not to execute the placement task.

Optionally, determining whether the specified tasks corresponding to the modules are executable based on the preset rules and the module information corresponding to the modules further includes:
in a case where the preset rules do not include the material first-in first-out rule, based on the judgment rule for determining whether the manipulator executes the placement task, if it is determined, according to the module information corresponding to the manipulator, that the manipulator is in the idle state and materials exist on the manipulator, determining whether the modules where the materials need to arrive at next steps are in the idle state and have idle slots;
if the modules where the materials need to arrive at the next steps meet a condition of being in the idle state and having the idle slots, determining that the manipulator can execute the placement task for the materials; and
if the modules where the materials need to arrive at the next steps do not meet the condition of being in the idle state and having the idle slots, determining that the manipulator cannot execute the placement task for the materials.

Optionally, determining whether the specified tasks corresponding to the modules are executable based on the preset rules and the module information corresponding to the modules includes:
in a case where the preset rules do not include a material first-in first-out rule, based on a judgment rule for determining whether the manipulator executes the pick-up task, if it is determined, according to the module information corresponding to the manipulator, that the manipulator is in an idle state and has an idle arm, determining whether a target module meeting a first preset condition exists among all the modules reachable by the manipulator; and the first preset condition is that a module is in an idle state, a material exists in the module, and a next step for the material is the manipulator executing the pick-up task, and the preset rules do not include a customized pick-up rule, or in a case where the preset rules include the customized pick-up rule, picking up the material by the manipulator to the needed module at the next step meets the customized pick-up rule; and
if the target module exists, determining that the manipulator can execute the pick-up task for a material in the target module.

Optionally, determining whether the specified tasks corresponding to the modules are executable based on the preset rules and the module information corresponding to the modules further includes:
in a case where the preset rules further include the material first-in first-out rule, based on the judgment rule for determining whether the manipulator can execute the pick-up task, if it is determined, according to the module information corresponding to the manipulator, that the manipulator is in the idle state and has an idle arm, grouping all the modules reachable by the manipulator according to types of the modules;
sequentially determining whether a material to be subjected to the pick-up task exists in each group;
if a material to be subjected to the pick-up task exists in a group and a material with a minimum material ID in the group meets a second preset condition, determining that the manipulator can execute the pick-up task for the material with the minimum material ID; and the second preset condition is that a module where a material is currently located is in an idle state, and the preset rules do not include the customized pick-up rule; or, in a case where the preset rules include the customized pick-up rule, picking up the material with the minimum material ID by the manipulator to a needed module at a next step meets the customized pick-up rule; and
if there is no material capable of being subjected to the pick-up task in any group, determining that the manipulator is not to execute the pick-up task.

Optionally, the exchange task corresponding to the manipulator includes a first exchange task that is to first pick and then put; and determining whether the specified tasks corresponding to the modules are executable based on the preset rules and the module information corresponding to the modules includes:
based on a judgment rule for determining whether the manipulator executes the first exchange task, if it is determined, according to the module information corresponding to the manipulator, that the manipulator is in an idle state and the manipulator has a material on one arm and has no material on another arm, determining whether a first candidate material which needs the manipulator to execute a pick-up task exists among all materials of the modules where the material on the manipulator needs to arrive at a next step;
in a case where the preset rules do not include a material first-in first-out rule, if it is determined that a first target material meeting a third preset condition exists in the first candidate material, determining that the manipulator can execute the first exchange task; and the third preset condition is that a module where a material is located is in an idle state, and the preset rules do not include a customized pick-up rule; or, in a case where the preset rules include the customized pick-up rule, a module to which the manipulator needs to move a material at a next step needs to meet the customized pick-up rule; and
in a case where the preset rules include the material first-in first-out rule, if a material with a minimum material ID in the first candidate material meets a fourth preset condition, determining that the manipulator can execute the first exchange task; and the fourth preset condition is that a module where a material with a minimum material ID is located is in an idle state, and the preset rules do not include a customized pick-up rule; or, in a case where the preset rules include the customized pick-up rule, a module to which the manipulator needs to move a material at a next step needs to meet the customized pick-up rule.

Optionally, the exchange task corresponding to the manipulator further includes a second exchange task that is to first put and then pick; and determining whether the specified tasks corresponding to the modules are executable based on the preset rules and the module information corresponding to the modules includes:
based on a judgment rule for determining whether the manipulator executes the second exchange task, if it is determined, according to the module information corresponding to the manipulator, that the manipulator is in the idle state and the manipulator has a material thereon, determining whether a second candidate material which needs the manipulator to execute the pick-up task exists among all materials of the modules where the material on the manipulator needs to arrive at a next step;
in a case where the preset rules do not include the material first-in first-out rule, if it is determined that a second target material meeting a fifth preset condition exists in the second candidate material, determining that the manipulator can execute the second exchange task; and the fifth preset condition is that a module where the second candidate material is located is in the idle state and has an idle slot, and the preset rules do not include a customized pick-up rule; or, in a case where the preset rules include the customized pick-up rule, the manipulator executing the pick-up task for the second candidate material needs to meet the customized pick-up rule; and
in a case where the preset rules include the material first-in first-out rule, if a material with a minimum material ID in the second candidate material meets a sixth preset condition, determining that the manipulator can execute the second exchange task; and the sixth preset condition is that a module where a material is located is in the idle state and has an idle slot, and the preset rules do not include a customized pick-up rule; or, in a case where the preset rules include the customized pick-up rule, the manipulator executing the pick-up task for the material needs to meet the customized pick-up rule.

Optionally, the method further includes:
before the modules start to execute the corresponding specified tasks, setting the module state information of the modules to be a busy state;
after the modules complete the corresponding specified tasks, setting the module state information of the modules to be an idle state;
after the placement task for a material by the manipulator is completed, setting the material existence information corresponding to the manipulator to be "no material", and setting the material existence information corresponding to a module where the material is currently located to be "with material"; and
after the pick-up task for a material by the manipulator is completed, setting the material existence information corresponding to a module where the material is originally located to be "no material", and setting the material existence information corresponding to the manipulator to be "with material".

Optionally, the method further includes:
after the process task for the material is completed in the process chamber, setting a state corresponding to the material to a processed state.

Optionally, the method further includes:
after the process task for the material is completed in the cooling module, setting a state corresponding to the material to a processed state.

Optionally, the method further includes:
after the pre-pumping chamber completes the vent task, setting the pre-pumping chamber to be in the atmospheric environment.

Optionally, the method further includes:
after the pre-pumping chamber completes the pump task, setting the pre-pumping chamber to be in the vacuum environment.

Optionally, the method further includes:
after the alignment task for the material is completed in the alignment module, setting a state corresponding to the material to an aligned state.

An embodiment of the present disclosure further discloses a semiconductor processing apparatus including a plurality of modules that are configured with corresponding specified tasks, and the semiconductor processing apparatus further includes:
a controller, which is configured to, for the plurality of modules, acquire module information corresponding to the modules one module by one module, and determine whether the specified tasks corresponding to the modules are executable based on preset rules and module information corresponding to the modules, with the module information including module state information and material existence information and the preset rules including rules for determining whether the modules execute the corresponding specified tasks; and if it is determined that the specified tasks corresponding to the modules are executable, control the modules to execute the corresponding specified tasks.

Optionally, the plurality of modules include: a process chamber, a pre-pumping chamber, a cooling module, a manipulator, and an alignment module; and
the preset rules include: a judgment rule for determining whether the process chamber executes a process task; judgment rules for determining whether the pre-pumping chamber executes a vent task and a pump task; a judgment rule for determining whether the cooling module executes a process task; a judgment rule for determining whether the alignment module executes an alignment task; and judgment rules for determining whether the manipulator executes a pick-up task, a placement task, and an exchange task.

Optionally, the controller is configured to, based on the judgment rule for determining whether the process chamber executes the process task, if it is determined, according to the module information corresponding to the process chamber, that the process chamber is in an idle state, a material exists in the process chamber, and the material is not subjected to the process task in the process chamber, determine that the process chamber can execute the process task.

Optionally, the controller is configured to, based on the judgment rule for determining whether the cooling module executes the process task, if it is determined, according to the module information corresponding to the cooling module, that the cooling module is in an idle state, a material exists in the cooling module, and the material is not subjected to the process task in the cooling module, determine that the cooling module can execute the process task.

Optionally, the manipulator includes an atmospheric manipulator, and the controller is configured to, based on the judgment rule for determining whether the pre-pumping chamber executes the vent task, if it is determined, according to the module information corresponding to the pre-pumping chamber, that there is a pre-pumping chamber which is in an idle state and is not in an atmospheric environment, determine whether a material exists in the pre-pumping chamber; if the material exists in the pre-pumping chamber and a next step for the material is the atmospheric manipulator picking up the material and placing the material into an atmospheric end, determine that the pre-pumping chamber can execute the vent task; and if there is no material in the pre-pumping chamber and the number of materials to be placed by the atmospheric manipulator into pre-pumping chambers is less than the number of pre-pumping chambers that are in the atmospheric environment, determine that the pre-pumping chamber can execute the vent task.

Optionally, the manipulator includes a vacuum manipulator, and the controller is configured to, based on the judgment rule for determining whether the pre-pumping chamber executes the pump task, if it is determined, according to the module information corresponding to the pre-pumping chamber, that there is a pre-pumping chamber which is in an idle state and is not in a vacuum environment, determine whether a material exists in the pre-pumping chamber; if the material exists in the pre-pumping chamber and a next step for the material is the vacuum manipulator picking up the material and placing the material into a vacuum end, determine that the pre-pumping chamber can execute the pump task; and if there is no material in the pre-pumping chamber and the number of materials to be placed by the vacuum manipulator into pre-pumping chambers is less than the number of pre-pumping chambers that are in the vacuum environment, determine that the pre-pumping chamber can execute the pump task.

Optionally, the controller is configured to, based on the judgment rule for determining whether the alignment module executes the alignment task, if it is determined, according to the module information corresponding to the alignment module, that the alignment module is in an idle state and materials not subjected to the alignment task exist in the alignment module, determine that the alignment module can execute the alignment task.

Optionally, the controller is configured to, in a case where the preset rules further include a material first-in first-out rule, based on the judgment rule for determining whether the manipulator executes the placement task, if it is determined, according to the module information corresponding to the manipulator, that the manipulator is in the idle state and materials exist on the manipulator, group the materials on the manipulator according to the modules where the materials need to arrive at next steps; sequentially determine material IDs of the materials in each group, and determine a material with the minimum material ID in each group, with the material IDs being set for the materials based on the material first-in first-out rule; if a module where a material with the minimum material ID in a group needs to arrive at a next step is in the idle state and has an idle slot, determine that the manipulator can execute the placement task for the material with the minimum material ID in the group; and if there is no material to be subjected to the placement task in any group, determine that the manipulator is not to execute the placement task.

Optionally, the controller is configured to, in a case where the preset rules do not include the material first-in first-out rule, based on the judgment rule for determining whether the manipulator executes the placement task, if it is determined, according to the module information corresponding to the manipulator, that the manipulator is in the idle state and materials exist on the manipulator, determine whether the modules where the materials need to arrive at next steps are in the idle state and have idle slots; if the modules where the materials need to arrive at the next steps meet a condition of being in the idle state and having the idle slots, determine that the manipulator can execute the placement task for the materials; and if the modules where the materials need to arrive at the next steps do not meet the condition of being in the idle state and having the idle slots, determine that the manipulator cannot execute the placement task for the materials.

Optionally, the controller is configured to, in a case where the preset rules do not include the material first-in first-out rule, based on the judgment rule for determining whether the manipulator executes the pick-up task, if it is determined, according to the module information corresponding to the manipulator, that the manipulator is in the idle state and has an idle arm, determine whether a target module meeting a first preset condition exists among all the modules reachable by the manipulator, with the first preset condition being that a module is in the idle state, a material exists in the module, and a next step for the material is the manipulator executing the pick-up task, and the preset rules not including a customized pick-up rule, or in a case where the preset rules include the customized pick-up rule, picking up the material by the manipulator to the needed module at the next step meeting the customized pick-up rule; and if the target module exists, determine that the manipulator can execute the pick-up task for the material in the target module.

Optionally, the controller is configured to, in a case where the preset rules further include the material first-in first-out rule, based on the judgment rule for determining whether the manipulator executes the pick-up task, if it is determined, according to the module information corresponding to the manipulator, that the manipulator is in the idle state and has an idle arm, group all the modules reachable by the manipulator according to types of the modules; sequentially determine whether a material to be subjected to the pick-up task exists in each group; if a material to be subjected to the pick-up task exists in a group and a material with the minimum material ID in the group meets a second preset condition, determine that the manipulator can execute the pick-up task for the material with the minimum material ID, with the second preset condition being that a module where a material is currently located is in the idle state, and the preset rules not including the customized pick-up rule, or in a case where the preset rules include the customized pick-up rule, picking up the material with the minimum material ID by the manipulator to a needed module at a next step meeting the customized pick-up rule; and if there is no material capable of being subjected to the pick-up task in any group, determine that the manipulator is not to execute the pick-up task.

Optionally, the exchange task corresponding to the manipulator includes a first exchange task that is to first pick and then put. The controller is configured to, based on the judgment rule for determining whether the manipulator executes the first exchange task, if it is determined, according to the module information corresponding to the manipulator, that the manipulator is in the idle state, and the manipulator has a material on one arm and has no material on another arm, determine whether a first candidate material which needs the manipulator to execute the pick-up task exists among all materials of the modules where the material on the manipulator needs to arrive at a next step; in a case where the preset rules do not include the material first-in first-out rule, if it is determined that a first target material meeting a third preset condition exists in the first candidate material, determine that the manipulator can execute the first exchange task, with the third preset condition being that a module where a material is located is in the idle state, and the preset rules not including a customized pick-up rule, or in a case where the preset rules include the customized pick-up rule, a module to which the manipulator needs to move a material at a next step meeting the customized pick-up rule; and in a case where the preset rules include the material first-in first-out rule, if a material with the minimum material ID in the first candidate material meets a fourth preset condition, determine that the manipulator can execute the first exchange task, with the fourth preset condition being that a module where a material with the minimum material ID is located is in the idle state, and the preset rules not including a customized pick-up rule, or in a case where the preset rules include the customized pick-up rule, a module to which the manipulator needs to move a material at a next step meeting the customized pick-up rule.

Optionally, the exchange task corresponding to the manipulator includes a second exchange task that is to first put and then pick. The controller is configured to, based on the judgment rule for determining whether the manipulator executes the second exchange task, if it is determined, according to the module information corresponding to the manipulator, that the manipulator is in the idle state and the manipulator has a material thereon, determine whether a second candidate material which needs the manipulator to execute the pick-up task exists among all materials of the modules where the material on the manipulator needs to arrive at a next step; in a case where the preset rules do not include the material first-in first-out rule, if it is determined that a second target material meeting a fifth preset condition exists in the second candidate material, determine that the manipulator can execute the second exchange task, with the fifth preset condition being that a module where the second candidate material is located is in the idle state and has an idle slot, and the preset rules not including a customized pick-up rule, or in a case where the preset rules include the customized pick-up rule, the manipulator executing the pick-up task for the second candidate material meeting the customized pick-up rule; and in a case where the preset rules include the material first-in first-out rule, if a material with the minimum material ID in the second candidate material meets a sixth preset condition, determine that the manipulator can execute the second exchange task, with the sixth preset condition being that a module where a material is located is in the idle state and has an idle slot, and the preset rules not including a customized pick-up rule, or in a case where the preset rules include the customized pick-up rule, the manipulator executing the pick-up task for the material meeting the customized pick-up rule.

Optionally, the controller is further configured to, before the modules start to execute the corresponding specified tasks, set the module state information of the modules to be a busy state; after the modules complete the corresponding specified tasks, set the module state information of the modules to be the idle state; after the placement task for a material by the manipulator is completed, set the material existence information corresponding to the manipulator to be "no material", and set the material existence information corresponding to a module where the material is currently located to be "with material"; and after the pick-up task for a material by the manipulator is completed, set the material existence information corresponding to a module where the material is originally located to be "no material", and set the material existence information corresponding to the manipulator to be "with material".

Optionally, the controller is further configured to set, after the process task for a material is completed in the process chamber, a state corresponding to the material to a processed state.

Optionally, the controller is further configured to set, after the process task for a material is completed in the cooling module, a state corresponding to the material to the processed state.

Optionally, the controller is further configured to set, after the pre-pumping chamber completes the vent task, the pre-pumping chamber to be in the atmospheric environment.

Optionally, the controller is further configured to set, after the pre-pumping chamber completes the pump task, the pre-pumping chamber to be in the vacuum environment.

Optionally, the controller is further configured to set, after the alignment task for a material is completed in the alignment module, a state corresponding to the material to an aligned state.

The embodiments of the present disclosure have the following advantages:
according to the embodiments of the present disclosure, the module information corresponding to the modules is acquired one module by one module, and whether the specified tasks corresponding to the modules are executable is determined based on the preset rules configured to determine whether the modules execute the corresponding specified tasks and the module state information and the material existence information corresponding to the modules; and if it is determined that the specified tasks corresponding to the modules are executable, the modules are controlled to execute the corresponding specified tasks. According to the embodiments of the present disclosure, instead of relying on the manually set execution time of the action task of each module, whether the specified tasks are executable is determined according to the current real-time module state information and the current real-time material existence information of the modules, so that the influence of inaccuracy of the manually set parameters is reduced; and a simple algorithm is adopted, the tasks executable by the modules can be quickly determined, idle time of each module for waiting for the tasks can be reduced, utilization of each module can be improved, and the equipment production capacity can be increased.

### BRIEF DESCRIPTION OF DRAWINGS

FIG. 1 is a schematic diagram of a transfer path of materials in an etching device;
FIG. 2 is another schematic diagram of a transfer path of materials in an etching device;
FIG. 3 is still another schematic diagram of a transfer path of materials in an etching device;
FIG. 4 is a flowchart of steps of a scheduling control method for a semiconductor process apparatus according to an embodiment of the present disclosure;
FIG. 5 is another flowchart of steps of a scheduling control method for a semiconductor process apparatus according to an embodiment of the present disclosure;
FIG. 6 is a flowchart of determining whether a process chamber can execute a process task based on preset rules according to an embodiment of the present disclosure;
FIG. 7 is a flowchart of determining whether a cooling module can execute a process task based on preset rules according to an embodiment of the present disclosure;
FIG. 8 is a flowchart of determining whether a pre-pumping chamber can execute a vent task based on preset rules according to an embodiment of the present disclosure;
FIG. 9 is a flowchart of determining whether a pre-pumping chamber can execute a pump task based on preset rules according to an embodiment of the present disclosure;
FIG. 10 is a flowchart of determining whether an alignment module can execute an alignment task based on preset rules according to an embodiment of the present disclosure;
FIG. 11 is a flowchart of determining whether a manipulator can execute a placement task based on preset rules according to an embodiment of the present disclosure;
FIG. 12 is a flowchart of determining whether a manipulator can execute a pick-up task based on preset rules according to an embodiment of the present disclosure;
FIG. 13 is a flowchart of determining whether a manipulator can execute a first exchange task based on preset rules according to an embodiment of the present disclosure;
FIG. 14 is a flowchart of determining whether a manipulator can execute a second exchange task based on preset rules according to an embodiment of the present disclosure;
FIG. 15 is a structural diagram of a material scheduling control system according to an example of the present disclosure; and
FIG. 16 is a block diagram of a semiconductor processing apparatus according to an embodiment of the present disclosure.

### DETAIL DESCRIPTION OF EMBODIMENTS

In order to make the above objectives, features and advantages of the present disclosure more obvious and understandable, the present disclosure is further described in detail below with reference to the drawings and specific implementations.

A scheduling control method for a semiconductor process apparatus according to the embodiments of the present disclosure is applicable to various types of semiconductor process apparatuses. Taking an etching device as an example, the etching device may include: a loading and unloading module (i.e., a Load port), a material buffer (i.e., a Buffer), a process chamber (i.e., a Processing Module (PM)), a pre-pumping chamber (i.e., a Load Lock), a cooling module (i.e., a Cooler), a manipulator (i.e., a Robot), and an alignment module (i.e., an Aligner).

The loading and unloading module is configured to provide an operation platform for loading a wafer box, and the wafer box is capable of carrying 25 materials. For example, the number of loading and unloading modules may be 3.

The alignment module is configured to align materials before the materials are transferred into the process chamber.

The material buffer is capable of carrying 25 materials, and is configured to prevent the processed materials and the unprocessed materials from being simultaneously stored in the wafer box.

The pre-pumping chamber is a connector between an atmosphere end and a vacuum end, and is capable of performing a pump action to discharge a gas from the pre-pumping chamber to enable the pre-pumping chamber to be in a vacuum environment. The pre-pumping chamber is also capable of performing a vent action to ventilate the pre-pumping chamber to restore the pre-pumping chamber to an atmospheric pressure and enable the pre-pumping chamber to be in an atmospheric environment. For example, the number of pre-pumping chambers may be 2 or 4.

The cooling module is configured to cool the processed materials.

The process chamber is configured to perform process tasks on the materials. For example, the number of process chambers may be 4 or 6.

The manipulator may include an atmospheric manipulator configured to transfer the materials among the wafer box, the material buffer, the alignment module, the cooling module, and the pre-pumping chamber.

The manipulator may further include a vacuum manipulator configured to transfer the materials between the pre-pumping chamber and the process chamber.

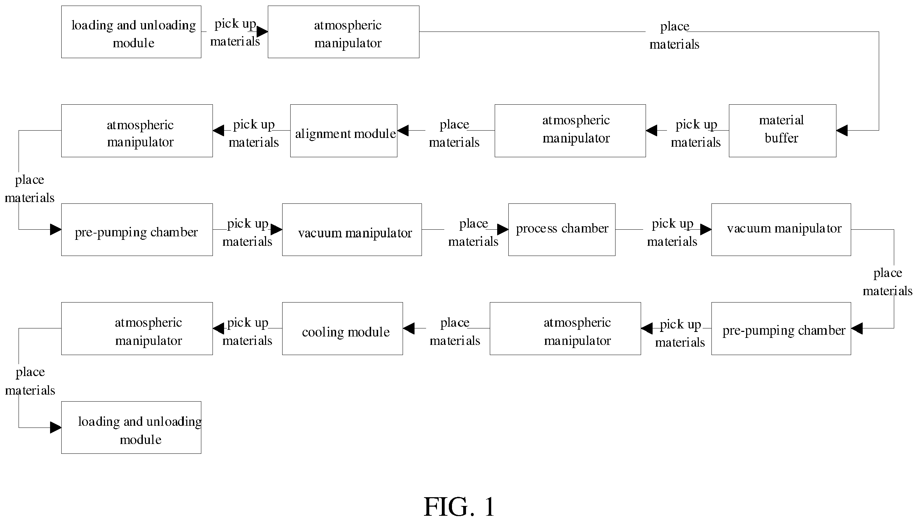

FIG. 1 is a schematic diagram of a transfer path of the materials in the etching device. Referring to FIG. 1, the transfer path of the materials is: the atmospheric manipulator picks up the materials (e.g., wafers) to be processed from the loading and unloading module and places the materials into the material buffer; when all the materials to be processed are loaded into the material buffer, the atmospheric manipulator picks up the materials from the material buffer and transfers the materials to the alignment module for alignment; after the alignment is completed, the atmospheric manipulator transfers the materials to the pre-pumping chamber; the vacuum manipulator transfers the materials from the pre-pumping chamber to the process chamber for processing; after the processing is completed, the vacuum manipulator transfers the materials from the process chamber back to the pre-pumping chamber; the atmospheric manipulator transfers the materials from the pre-pumping chamber to the cooling module for cooling; and after the cooling is completed, the atmospheric manipulator transfers the materials to the loading and unloading module. In the transfer path, the material buffer is configured to load the unprocessed materials, and the loading and unloading module is configured to load the processed materials.

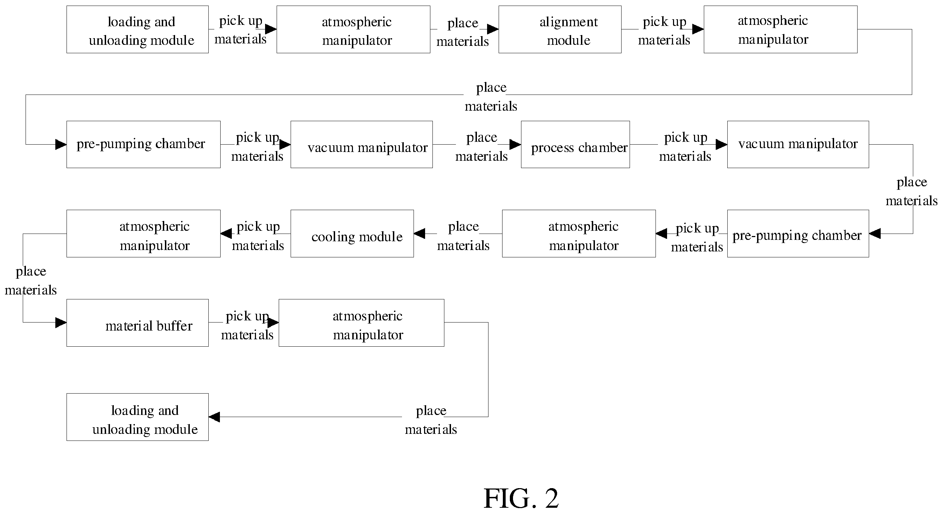

FIG. 2 is another schematic diagram of a transfer path of the materials in the etching device. Referring to FIG. 2, the transfer path of the materials is: the atmospheric manipulator picks up the materials (e.g., wafers) to be processed from the loading and unloading module and places the materials into the alignment module for alignment; after the alignment is completed, the atmospheric manipulator transfers the materials to the pre-pumping chamber; the vacuum manipulator transfers the materials from the pre-pumping chamber to the process chamber for processing; after the processing is completed, the vacuum manipulator transfers the materials from the process chamber back to the pre-pumping chamber; the atmospheric manipulator transfers the materials from the pre-pumping chamber to the cooling module for cooling; after the cooling is completed, the atmospheric manipulator transfers the materials to the material buffer; and when all the materials are transferred to the material buffer, the atmospheric manipulator transfers the materials to the loading and unloading module. In the transfer path, the material buffer is configured to load the processed materials, and the loading and unloading module is configured to load the unprocessed materials.

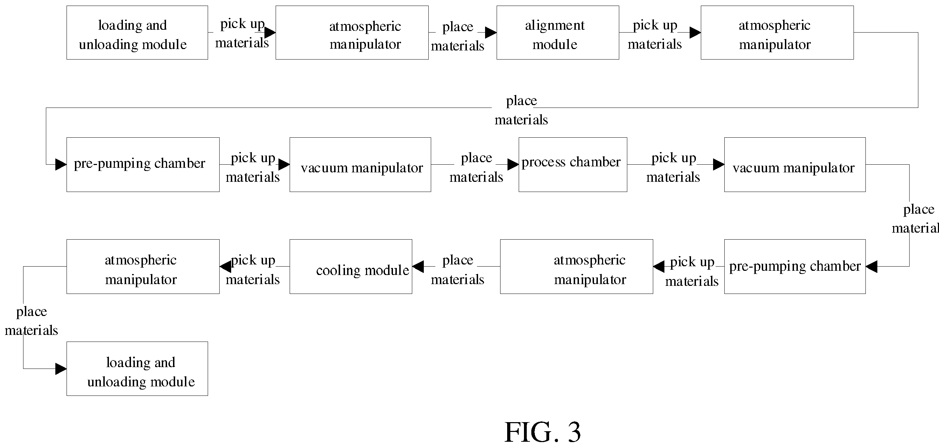

FIG. 3 is still another schematic diagram of a transfer path of the materials in the etching device. Referring to FIG. 3, the transfer path of the materials is: the atmospheric manipulator picks up the materials (e.g., wafers) to be processed from the loading and unloading module and places the materials into the alignment module for alignment; after the alignment is completed, the atmospheric manipulator transfers the materials to the pre-pumping chamber; the vacuum manipulator transfers the materials from the pre-pumping chamber to the process chamber for processing; after the processing is completed, the vacuum manipulator transfers the materials from the process chamber back to the pre-pumping chamber; the atmospheric manipulator transfers the materials from the pre-pumping chamber to the cooling module for cooling; and after the cooling is completed, the atmospheric manipulator transfers the materials to the loading and unloading module. In the transfer path, the material buffer is not used.

For the material scheduling control of the semiconductor process apparatus, one of the core concepts of the embodiments of the present disclosure is to determine whether a specified task corresponding to a module is executable based on a preset rule configured to determine whether the module executes the corresponding specified task, and module state information and material existence information which are acquired in real time.

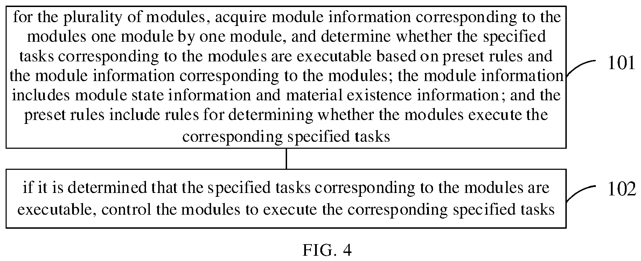

Referring to FIG. 4 which is a flowchart of steps of a scheduling control method for a semiconductor process apparatus according to an embodiment of the present disclosure, the semiconductor process apparatus includes a plurality of modules that are configured with corresponding specified tasks, and the method may specifically include the following steps 101 and 102.

At step 101, for the plurality of modules, module information corresponding to the modules is acquired one module by one module, and whether the specified tasks corresponding to the modules are executable is determined based on preset rules and the module information corresponding to the modules; the module information includes module state information and material existence information; and the preset rules include rules for determining whether the modules execute the corresponding specified tasks.

The semiconductor process apparatus may include various types of modules, and the number of each type of module may be one or more. For the plurality of modules, whether the specified tasks corresponding to the modules are executable may be determined one module by one module at a preset interval (e.g., 100ms).

For example, whether a process task of each process chamber is executable, whether a process task of each cooling module is executable, whether a pump task of each pre-pumping chamber is executable, whether a vent task of each pre-pumping chamber is executable, whether an alignment task of each alignment module is executable, and whether a pick-up task or a placement task of each manipulator is executable may be sequentially determined for the etching device.

When determining whether the specified tasks corresponding to the modules are executable, current module information of the modules need to be acquired, and the module information includes the module state information and the material existence information. The module state information refers to information for indicating current states of the modules, for example, the states of the modules may be divided into an idle state and a busy state. The material existence information is information for indicating whether materials currently exist in the modules.

The preset rules may include basic scheduling rules for determining whether the modules execute the corresponding specified tasks. For each module, the basic scheduling rule corresponding to the module and the current module information corresponding to the module need to be used for determining whether the specified task corresponding to the module is executable. If the semiconductor process apparatus has a process requirement on material scheduling, a specific rule may be added as required based on the basic scheduling rule for each task.

At step 102, if it is determined that the specified tasks corresponding to the modules are executable, the modules are controlled to execute the corresponding specified tasks.

If it is determined that the specified tasks corresponding to the modules are executable, the modules are controlled to execute the corresponding specified tasks; and if it is determined that a specified task corresponding to a module is not executable, it is waited to determine whether a specified task corresponding to a next module is executable.

According to the embodiments of the present disclosure, the module information corresponding to the modules is acquired one module by one module, and whether the specified tasks corresponding to the modules are executable is determined based on the preset rules configured to determine whether the modules execute the corresponding specified tasks and the module state information and the material existence information corresponding to the modules; and if it is determined that the specified tasks corresponding to the modules are executable, the modules are controlled to execute the corresponding specified tasks. According to the embodiments of the present disclosure, instead of relying on the manually set execution time of the action task of each module, whether the specified tasks are executable is determined according to the current real-time module state information and the current real-time material existence information of the modules, so that the influence of inaccuracy of the manually set parameters is reduced; and a simple algorithm is adopted, the tasks executable by the modules can be quickly determined, idle time of each module for waiting for the tasks can be reduced, utilization of each module can be improved, and the equipment production capacity can be increased.

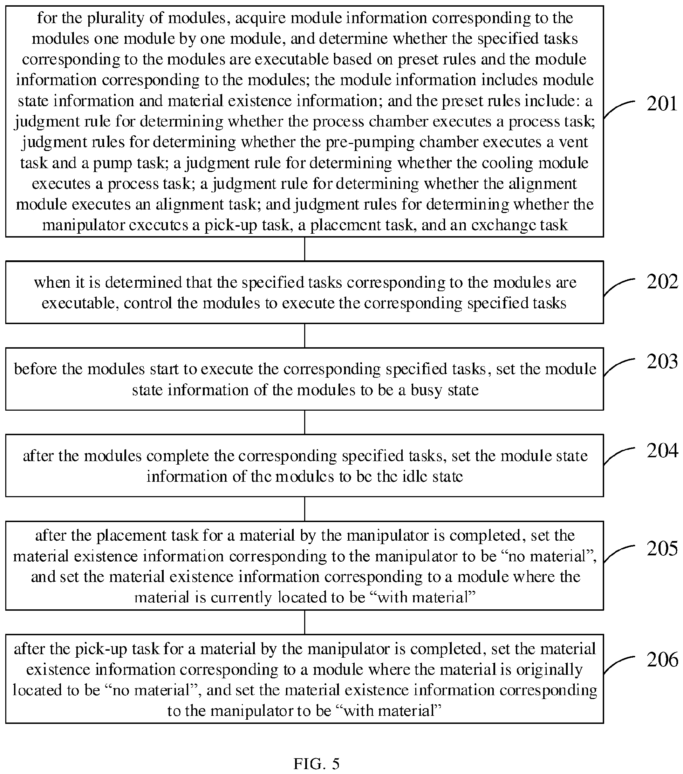

Referring to FIG. 5 which is another flowchart of steps of a scheduling control method for a semiconductor process apparatus according to an embodiment of the present disclosure, the semiconductor process apparatus includes a plurality of modules that include: a process chamber, a pre-pumping chamber, a cooling module, a manipulator, and an alignment module; and the plurality of modules are configured with corresponding specified tasks, and the method may specifically include the following steps 201 to 206.

At step 201, for the plurality of modules, module information corresponding to the modules is acquired one module by one module, and whether the specified tasks corresponding to the modules are executable is determined based on preset rules and the module information corresponding to the modules; the module information includes module state information and material existence information; and the preset rules include: a judgment rule for determining whether the process chamber executes a process task; judgment rules for determining whether the pre-pumping chamber executes a vent task and a pump task; a judgment rule for determining whether the cooling module executes a process task; a judgment rule for determining whether the alignment module executes an alignment task; and judgment rules for determining whether the manipulator executes a pick-up task, a placement task, and an exchange task.

Whether each module can execute the corresponding specified task is explained below one by one.

In an embodiment, for the process task corresponding to the process chamber, the step of determining whether the specified tasks corresponding to the modules are executable based on the preset rules and the module information corresponding to the modules may include: based on the judgment rule for determining whether the process chamber executes the process task, if it is determined, according to the module information corresponding to the process chamber, that the process chamber is in the idle state, a material exists in the process chamber, and the material is not subjected to the process task in the process chamber, determining that the process chamber can execute the process task.

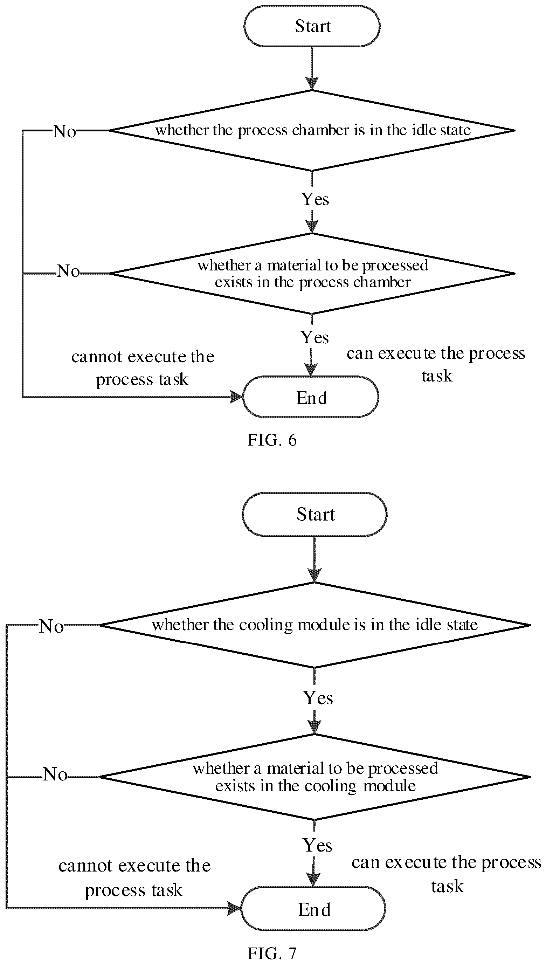

FIG. 6 is a flowchart of determining whether a process chamber can execute a process task based on the preset rules according to an embodiment of the present disclosure. Referring to FIG. 6, it is first determined whether the process chamber is in the idle state; if the process chamber is not in the idle state, it is determined that the process chamber cannot execute the process task; if the process chamber is in the idle state, it is determined whether a material to be subjected to the process task exists in the process chamber; if no material in the process chamber needs to be subjected to the process task, it is determined that the process chamber cannot execute the process task; and if the material to be subjected to the process task exists in the process chamber, it is determined that the process chamber can execute the process task for the material.

In an embodiment, for the process task corresponding to the cooling module, the step of determining whether the specified tasks corresponding to the modules are executable based on the preset rules and the module information corresponding to the modules may include: based on the judgment rule for determining whether the cooling module executes the process task, if it is determined, according to the module information corresponding to the cooling module, that the cooling module is in the idle state, a material exists in the cooling module, and the material is not subjected to the process task in the cooling module, determining that the cooling module can execute the process task.

FIG. 7 is a flowchart of determining whether a cooling module can execute a process task based on the preset rules according to an embodiment of the present disclosure. Referring to FIG. 7, it is first determined whether the cooling module is in the idle state; if the cooling module is not in the idle state, it is determined that the cooling module cannot execute the process task; if the cooling module is in the idle state, it is determined whether a material to be subjected to the process task exists in the cooling module; if no material in the cooling module needs to be subjected to the process task, it is determined that the cooling module cannot execute the process task; and if the material to be subjected to the process task exists in the cooling module, it is determined that the cooling module can execute the process task for the material.

In an embodiment, for the vent task corresponding to the pre-pumping chamber, the step of determining whether the specified tasks corresponding to the modules are executable based on the preset rules and the module information corresponding to the modules may include the following sub-steps:
sub-step S11, based on the judgment rule for determining whether the pre-pumping chamber executes the vent task, if it is determined, according to the module information corresponding to the pre-pumping chamber, that there is a pre-pumping chamber which is in the idle state and is not in the atmospheric environment, determining whether a material exists in the pre-pumping chamber;
sub-step S12, if the material exists in the pre-pumping chamber and a next step for the material is the atmospheric manipulator picking up the material and placing the material into the atmospheric end, determining that the pre-pumping chamber can execute the vent task; and
sub-step S13, if there is no material in the pre-pumping chamber and the number of materials to be placed by the atmospheric manipulator into pre-pumping chambers is less than the number of pre-pumping chambers that are in the atmospheric environment, determining that the pre-pumping chamber can execute the vent task.

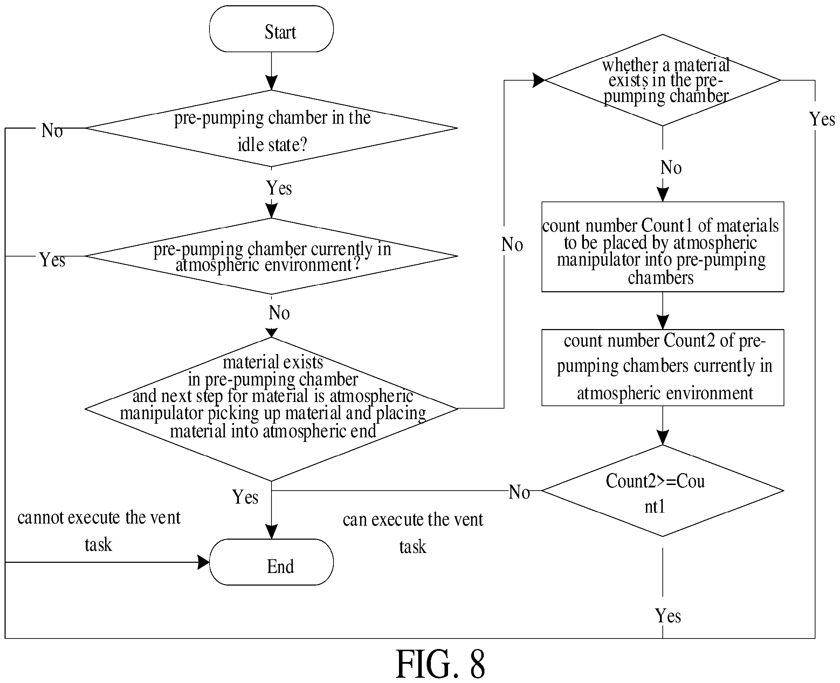

FIG. 8 is a flowchart of determining whether a pre-pumping chamber can execute a vent task based on the preset rules according to an embodiment of the present disclosure. Referring to FIG. 8, it is first determined whether the pre-pumping chamber is in the idle state; if the pre-pumping chamber is not in the idle state, it is determined that the pre-pumping chamber cannot execute the vent task; if the pre-pumping chamber is in the idle state, it is determined whether the pre-pumping chamber is currently in the atmospheric environment; if the pre-pumping chamber is currently in the atmospheric environment, it is determined that the pre-pumping chamber cannot execute the vent task; if the pre-pumping chamber is currently not in the atmospheric environment, it is determined whether a material exists in the pre-pumping chamber and a next step for the material is the atmospheric manipulator picking up the material and placing the material into the atmospheric end; if the material exists in the pre-pumping chamber and the next step for the material is the atmospheric manipulator picking up the material and placing the material into the atmospheric end, it is determined that the pre-pumping chamber can execute the vent task; if the pre-pumping chamber does not meet the condition that the material exists in the pre-pumping chamber and the next step for the material is the atmospheric manipulator picking up the material and placing the material into the atmospheric end, it is determined whether a material exists in the pre-pumping chamber; if the material exists in the pre-pumping chamber, it is determined that the pre-pumping chamber cannot execute the vent task; if there is no material in the pre-pumping chamber, the number Count1 of the materials to be placed by the atmospheric manipulator into pre-pumping chambers is counted, and the number Count2 of pre-pumping chambers that are currently in the atmospheric environment is counted; it is determined whether Count2 is greater than or equal to Count 1, and if Count2 is greater than or equal to Count1, it is determined that the pre-pumping chamber cannot execute the vent task; and if Count2 is less than Count1, it is determined that the pre-pumping chamber can execute the vent task.

For example, assuming that there is Scenario 1 in which the pre-pumping chambers include LA, LB, LC and LD, LA, LB, LC and LD are in the following situations: LA: there is one material in LA, a next step for the material is entering the vacuum end and being processed in the process chamber, LA is in the atmospheric environment, and LA is in the idle state; LB: there is no material in LB, LB is in the vacuum environment, and LB is in the idle state; LC: there is one material in LC, a next step for the material is returning to the atmospheric end, LC is in the vacuum environment, and LC is in the idle state; and LD: there is no material in LD, LD is in the vacuum environment, and LD is in the idle state. The atmospheric manipulator currently needs to place two materials thereon into the pre-pumping chambers; and the vacuum manipulator currently needs to place one material thereon into a pre-pumping chamber.

In the Scenario 1, LB, LC, and LD meet the condition that the pre-pumping chambers are currently in the idle state and are currently not in the atmospheric environment. Based on a condition in the preset rules that a pre-pumping chamber can execute a vent task if a material currently exists in the pre-pumping chamber and a next step for the material is entering the atmosphere end (i.e., the atmospheric manipulator picking up the material), LC in the Scenario 1 meets the condition and thus can execute the vent task.

Based on a condition in the preset rules, a pre-pumping chamber can execute a vent task if there is currently no material in the pre-pumping chamber and the number of materials to be placed by the atmospheric manipulator into pre-pumping chambers is less than the number of all pre-pumping chambers that are in the atmospheric environment. In the Scenario 1, the atmospheric manipulator needs to place two materials into the pre-pumping chambers, so that the number of pre-pumping chambers that need to be in the atmospheric environment is 2. In the Scenario 1, only LA is in the atmospheric environment, so LB can execute the vent task.

In an embodiment, for the pump task corresponding to the pre-pumping chamber, the step of determining whether the specified tasks corresponding to the modules are executable based on the preset rules and the module information corresponding to the modules may include the following sub-steps:
sub-step S21, based on the judgment rule for determining whether the pre-pumping chamber executes the pump task, if it is determined, according to the module information corresponding to the pre-pumping chamber, that there is a pre-pumping chamber which is in the idle state and is not in the vacuum environment, determining whether a material exists in the pre-pumping chamber;
sub-step S22, if the material exists in the pre-pumping chamber and a next step for the material is the vacuum manipulator picking up the material and placing the material into the vacuum end, determining that the pre-pumping chamber can execute the pump task; and
sub-step S23, if there is no material in the pre-pumping chamber and the number of materials to be placed by the vacuum manipulator into pre-pumping chambers is less than the number of pre-pumping chambers that are in the vacuum environment, determining that the pre-pumping chamber can execute the pump task.

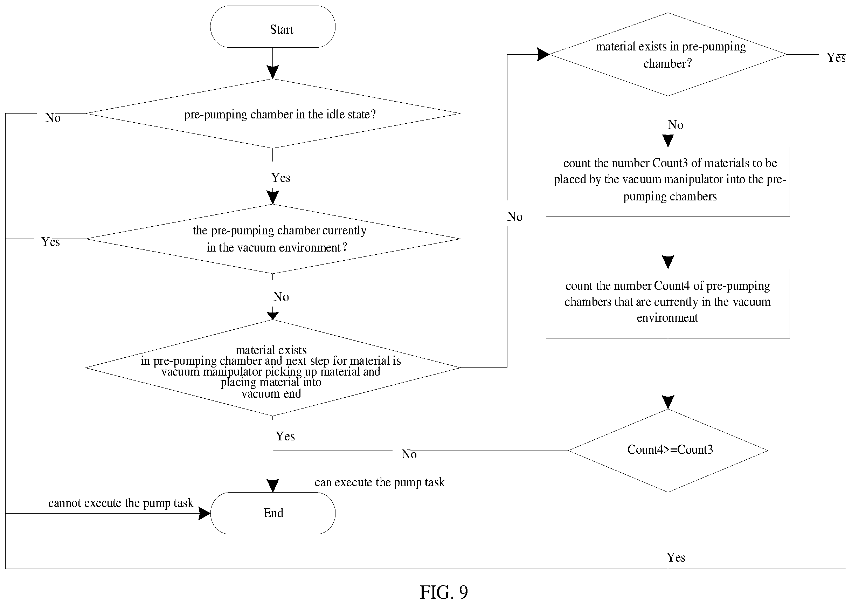

FIG. 9 is a flowchart of determining whether a pre-pumping chamber can execute a pump task based on the preset rules according to an embodiment of the present disclosure. Referring to FIG. 9, it is first determined whether the pre-pumping chamber is in the idle state; if the pre-pumping chamber is not in the idle state, it is determined that the pre-pumping chamber cannot execute the pump task; if the pre-pumping chamber is in the idle state, it is determined whether the pre-pumping chamber is currently in the vacuum environment; if the pre-pumping chamber is currently in the vacuum environment, it is determined that the pre-pumping chamber cannot execute the pump task; if the pre-pumping chamber is currently not in the vacuum environment, it is determined whether a material exists in the pre-pumping chamber and a next step for the material is the vacuum manipulator picking up the material and placing the material into the vacuum end; if the material exists in the pre-pumping chamber and the next step for the material is the vacuum manipulator picking up the material and placing the material into the vacuum end, it is determined that the pre-pumping chamber can execute the pump task; if the pre-pumping chamber does not meet the condition that the material exists in the pre-pumping chamber and the next step for the material is the vacuum manipulator picking up the material and placing the material into the vacuum end, it is determined whether a material exists in the pre-pumping chamber; if the material exists in the pre-pumping chamber, it is determined that the pre-pumping chamber cannot execute the pump task; if there is no material in the pre-pumping chamber, the number Count3 of materials to be placed by the vacuum manipulator into the pre-pumping chambers is counted, and the number Count4 of pre-pumping chambers that are currently in the vacuum environment is counted; it is determined whether Count4 is greater than or equal to Count3, and if Count4 is greater than or equal to Count3, it is determined that the pre-pumping chamber cannot execute the pump task; and if Count4 is less than Count3, it is determined that the pre-pumping chamber can execute the pump task.

Taking the Scenario 1 as an example, based on a condition in the preset rules that a pre-pumping chamber can execute the pump task if a material currently exists in the pre-pumping chamber and a next step for the material is entering the vacuum end (i.e., the vacuum manipulator picking up the material), in the Scenario 1, LC meets the condition and thus can execute the pump task. Based on a condition in the preset rules, a pre-pumping chamber can execute the pump task if there is currently no material in the pre-pumping chamber and the number of materials need to be placed by the vacuum manipulator into the pre-pumping chamber is less the number of all pre-pumping chambers that are in the vacuum environment. In the Scenario 1, the number of pre-pumping chambers that need to be in the vacuum environment is 1, and the number of pre-pumping chambers that are in the vacuum environment is greater than 1, so the pre-pumping chambers except the LC do not need to execute the pump task.

In an embodiment, for the alignment task corresponding to the alignment module, the step of determining whether the specified tasks corresponding to the modules are executable based on the preset rules and the module information corresponding to the modules may include: based on the judgment rule for determining whether the alignment module executes the alignment task, if it is determined, according to the module information corresponding to the alignment module, that the alignment module is in the idle state and materials not subjected to the alignment task exist in the alignment module, determining that the alignment module can execute the alignment task.

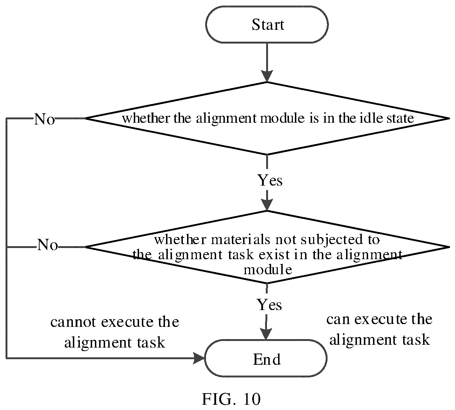

FIG. 10 is a flowchart of determining whether an alignment module can execute an alignment task based on the preset rules according to an embodiment of the present disclosure. Referring to FIG. 10, it is first determined whether the alignment module is in the idle state; if the alignment module is not in the idle state, it is determined that the alignment module cannot execute the alignment task; if the alignment module is in the idle state, it is determined whether materials not subjected to the alignment task exist in the alignment module; if there are no materials to be subjected to the alignment task in the alignment module, it is determined that the alignment module cannot execute the alignment task; and if the materials not subjected to the alignment task exist in the alignment module, it is determined that the alignment module can execute the alignment task for the materials.

In an embodiment, for the placement task corresponding to the manipulator, the step of determining whether the specified tasks corresponding to the modules are executable based on the preset rules and the module information corresponding to the modules may include the following sub-steps S31 to S37.

At sub-step S31, in a case where the preset rules further include a material first-in first-out rule, based on the judgment rule for determining whether the manipulator executes the placement task, if it is determined, according to the module information corresponding to the manipulator, that the manipulator is in the idle state and materials exist on the manipulator, the materials on the manipulator are grouped according to the modules where the materials need to arrive at next steps.

The material first-in first-out rule refers to that, when the process tasks are executed, a material which is first picked up from a wafer box into the device is required to be first returned to the wafer box after processing of the material is completed. The materials in the wafer box are sequentially picked up from the wafer box in ascending order of material IDs, and are returned to the wafer box in ascending order of material IDs. Therefore, the material entering the device earlier has the smaller material ID. According to the material first-in first-out rule, when a plurality of materials may be selected for a same process task, the material with the minimum material ID is preferentially selected to be subjected to the process task.

At sub-step S32, the material IDs of the materials in each group are sequentially determined, and a material with the minimum material ID in each group is determined; and the material IDs are set for the materials based on the material first-in first-out rule.

At sub-step S33, if a module where a material with the minimum material ID in a group needs to arrive at a next step is in the idle state and has an idle slot, it is determined that the manipulator can execute the placement task for the material with the minimum material ID in the group.

According to the material first-in first-out rule, the material with the minimum material ID needs to be returned to the wafer box first, so that the placement task is preferentially executed on the material with the minimum material ID.

At sub-step S34, if there is no material to be subjected to the placement task in any group, it is determined that the manipulator is not to execute the placement task.

At sub-step S35, in a case where the preset rules do not include the material first-in first-out rule, based on the judgment rule for determining whether the manipulator executes the placement task, if it is determined, according to the module information corresponding to the manipulator, that the manipulator is in the idle state and materials exist on the manipulator, it is determined whether the modules where the materials need to arrive at next steps are in the idle state and have idle slots.

At sub-step S36, if the modules where the materials need to arrive at the next steps meet a condition of being in the idle state and having the idle slots, it is determined that the manipulator can execute the placement task for the materials.

At sub-step S37, if the modules where the materials need to arrive at the next steps do not meet the condition of being in the idle state and having the idle slots, it is determined that the manipulator cannot execute the placement task for the materials.

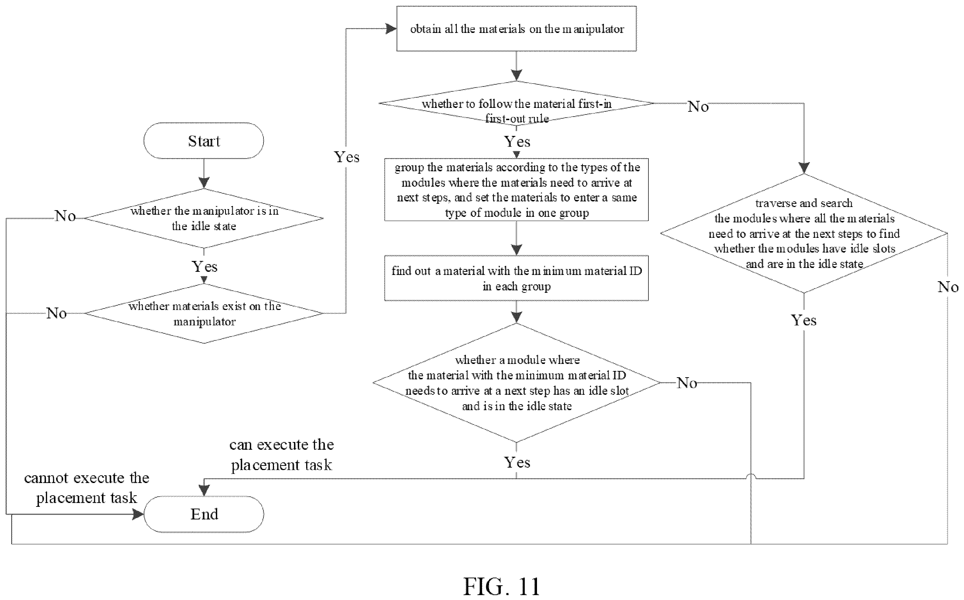

FIG. 11 is a flowchart of determining whether a manipulator can execute a placement task based on the preset rules according to an embodiment of the present disclosure. Referring to FIG. 11, it is first determined whether the manipulator is in the idle state; if the manipulator is not in the idle state, it is determined that the manipulator cannot execute the placement task; if the manipulator is in the idle state, it is determined whether materials exist on the manipulator; if there is no material on the manipulator, it is determined that the manipulator cannot execute the placement task; if the materials exist on the manipulator, it is determined whether to follow the material first-in first-out rule; if following the material first-in first-out rule, the materials are grouped according to the types of the modules where the materials need to arrive at next steps, so as to set the materials to enter a same type of module in one group; a material with the minimum material ID in each group is found; it is sequentially determined whether a module where the material with the minimum material ID in each group needs to arrive at a next step has an idle slot and is in the idle state; if a module where a material with the minimum material ID in a group needs to arrive at a next step is in the idle state and has an idle slot, it is determined that the manipulator can execute the placement task for the material with the minimum material ID in the group; and if there is no material to be subjected to the placement task in any group, it is determined that the manipulator is not to execute the placement task.

If not following the material first-in first-out rule, the modules where all the materials need to arrive at the next steps are traversed and searched to find whether the modules have idle slots and are in the idle state; if a module where a material needs to arrive at a next step is in the idle state and has an idle slot, it is determined that the manipulator can execute the placement task for the material; and if none of the modules where all the materials need to arrive at the next steps is in the idle state and has an idle slot, it is determined that the manipulator cannot execute the placement task.

For example, assuming that there is Scenario 2 in which two materials exist on the vacuum manipulator, the two materials are Material 2 (with an ID of 2) and Material 1 (with an ID of 1) in sequence, and both need to enter a process chamber; and Process Chamber 1 is in the idle state and has an idle slot.

Assuming that there is Scenario 3 in which two materials exist on the vacuum manipulator, the two materials are Material 2 (with an ID of 2) and Material 1 (with an ID of 1) in sequence, the Material 2 needs to enter a process chamber for a process task, a process task for the Material 1 is completed, and the Material 1 needs to enter a pre-pumping chamber; all pre-pumping chambers are in the busy state; and Process Chamber 1 is in the idle state and has an idle slot.

It is determined based on the preset rules: the vacuum manipulator is in the idle state and the materials exist on the vacuum manipulator, if following the material first-in first-out rule, whether the vacuum manipulator can execute the placement task is determined by the following steps.

All materials on the vacuum manipulator are grouped according to the modules where the materials need to arrive at next steps. For example, possible group types for the vacuum manipulator may be as follows.

Group Type 1: two materials exist on the vacuum manipulator, one needs to enter a process chamber for a process task, and the other needs to enter a pre-pumping chamber (to be returned to a wafer box). Since the modules needed for the next steps for the two materials are different, the two materials are divided into two groups. Moreover, according to the material first-in first-out principle, the material ID of the material to enter the pre-pumping chamber needs to be smaller than the material ID of the material to enter the process chamber.

Group Type 2: two materials exist on the vacuum manipulator, and both need to enter the process chambers at the next steps, so the two materials are set into one group.

Group Type 3: two materials exist on the vacuum manipulator, and both need enter the pre-pumping chambers at the next steps, so the two materials are set into one group.

Group Type 4: one material exists on the vacuum manipulator, so the one material is set into one group.

Each group is traversed to find a material with the minimum material ID in each group. If a module where a material with the minimum material ID in a group needs to arrive is in the idle state and has an idle slot, that is, the material to be subjected to the placement task is found in such group, a next group is not traversed.

For the Scenario 2, the materials on the vacuum manipulator are set into one group, the material with the minimum material ID is the Material 1, and the Material 1 can be placed into the process chamber.

For the Scenario 3, the materials on the vacuum manipulator are divided into two groups, and the materials with the minimum material IDs in the two groups are respectively the Material 2 and the Material 1. The Material 1 cannot be placed into the pre-pumping chamber (because all the pre-pumping chambers are in the busy state), while the Material 2 can be placed into the process chamber. Therefore, in the Scenario 3, it is found that the vacuum manipulator can execute the placement task for the Material 2 to place the Material 2 into the Process Chamber 1. If directly searching for a material with the minimum material ID without grouping the materials, the Material 1 may be found in the Scenario 3. However, since the Material 1 cannot be placed into the pre-pumping chamber, the vacuum manipulator cannot execute the placement task under the condition that it is determined that the vacuum manipulator can execute the placement task; and if a material capable of being placed is not found in any group, the vacuum manipulator cannot execute the placement task.

If not following the material first-in first-out rule, only a material meeting the following condition needs to be found on the vacuum manipulator: a module where the material needs to arrive at a next step is in the idle state and has an idle slot. Once such material is found, the vacuum manipulator can execute the placement task for the material. When the materials in the Scenario 2 are searched sequentially, the Material 2 may be found to be first placed into the Process Chamber 1.

In an embodiment, for the pick-up task corresponding to the manipulator, the step of determining whether the specified tasks corresponding to the modules are executable based on the preset rules and the module information corresponding to the modules may include the following sub-steps S41 to S46.

At sub-step S41, in a case where the preset rules do not include the material first-in first-out rule, based on the judgment rule for determining whether the manipulator executes the pick-up task, if it is determined, according to the module information corresponding to the manipulator, that the manipulator is in the idle state and has an idle arm, it is determined whether a target module meeting a first preset condition exists among all the modules reachable by the manipulator; and the first preset condition is that a module is in the idle state, a material exists in the module, and a next step for the material is the manipulator executing the pick-up task, and the preset rules do not include a customized pick-up rule, or in a case where the preset rules include the customized pick-up rule, picking up the material by the manipulator to the needed module at the next step meets the customized pick-up rule.

At sub-step S42, if the target module exists, it is determined that the manipulator can execute the pick-up task for the material in the target module.

At sub-step S43, in a case where the preset rules further include the material first-in first-out rule, based on the judgment rule for determining whether the manipulator can execute the pick-up task, if it is determined, according to the module information corresponding to the manipulator, that the manipulator is in the idle state and has an idle arm, all the modules reachable by the manipulator are grouped according to the types of the modules.

At sub-step S44, it is sequentially determined whether a material to be subjected to the pick-up task exists in each group.

At sub-step S45, if a material to be subjected to the pick-up task exists in a group and a material with the minimum material ID in the group meets a second preset condition, it is determined that the manipulator can execute the pick-up task for the material with the minimum material ID; and the second preset condition is that a module where a material is currently located is in the idle state, and the preset rules do not include the customized pick-up rule, or in a case where the preset rules include the customized pick-up rule, picking up the material with the minimum material ID by the manipulator to the needed module at a next step meets the customized pick-up rule.

The customized pick-up rule refers to a rule for determining whether the pick-up task is executable. For example, the customized pick-up rule may include an anti-deadlock scheduling rule. For example, the anti-deadlock scheduling rule may be: after the manipulator picks up a material, a module where the material needs to arrive at a next step needs to have an idle slot for the placement of the material. Different customized pick-up rules may be set for different semiconductor process apparatuses.

According to the material first-in first-out rule, the material with the minimum material ID needs to be returned to the wafer box first, so that the pick-up task is preferentially executed for the material with the minimum material ID.

At sub-step S46, if there is no material capable of being subjected to the pick-up task in any group, it is determined that the manipulator is not to execute the pick-up task.

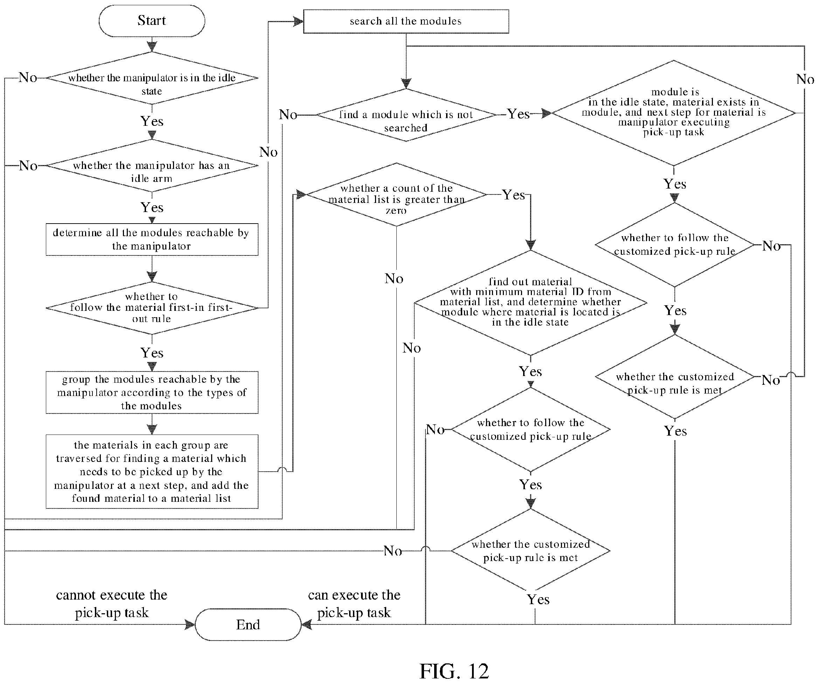

FIG. 12 is a flowchart of determining whether a manipulator can execute a pick-up task based on the preset rules according to an embodiment of the present disclosure. Referring to FIG. 12, it is first determined whether the manipulator is in the idle state; if the manipulator is not in the idle state, it is determined that the manipulator cannot execute the pick-up task; if the manipulator is in the idle state, it is determined whether the manipulator has an idle arm; if the manipulator has no idle arm, it is determined that the manipulator cannot execute the pick-up task; if the manipulator has the idle arm, all the modules reachable by the manipulator are determined; and it is determined whether to follow the material first-in first-out rule .

If not following the material first-in first-out rule, all the modules are sequentially searched to determine whether each module meets a condition that a module is in the idle state, a material exists in the module, and a next step for the material is the manipulator executing the pick-up task; if a module does not meet the condition that the module is in the idle state, the material exists in the module, and the next step for the material is the manipulator executing the pick-up task, a next module is searched; if it is found by search that a module is in the idle state, a material exists in the module, and a next step for the material is the manipulator executing the pick-up task, it is determined whether to follow the customized pick-up rule; if not following the customized pick-up rule, it is determined that the manipulator can execute the pick-up task for the material in the module; if following the customized pick-up rule, it is determined whether executing the pick-up task for the material in the module meets the customized pick-up rule; if the customized pick-up rule is not met, a next module is searched; and if the customized pick-up rule is met, it is determined that the manipulator can execute the pick-up task for the material in the module.

If following the material first-in first-out rule, all the modules reachable by the manipulator are grouped according to the types of the modules. For example, all the modules reachable by the atmospheric manipulator may be grouped as follows: all loading and unloading modules are in one group, all material buffers are in one group, all alignment modules are in one group, all cooling modules are in one group, and all pre-pumping chambers are in one group; and all the modules reachable by the vacuum manipulator may be grouped as follows: all process chambers are in one group, and all pre-pumping chambers are in one group.

Assuming that there is Scenario 4 in which all the pre-pumping chambers reachable by the vacuum manipulator are grouped together, each of the pre-pumping chambers has the following material existence situation: LA: Material 10 (with an ID of 10) exists in LA and needs to enter a process chamber, Material 2 (with an ID of 2) exists in LA and needs to be returned to a loading and unloading module, and LA is in the idle state; LB: Material 3 (with an ID of 3) exists in LB and needs to be returned to a loading and unloading module, and LB is in the idle state; LC: Material 11 (with an ID of 11) exists in LC and needs to enter a process chamber, Material 12 (with an ID of 12) exists in LC and needs to enter a process chamber, and LC is in the idle state; LD: there is no material in LD, and LD is in the idle state.

Each group is traversed for finding a material capable of being subjected to the pick-up task from all the modules in each group in a following way: all the materials in all the modules in each group are acquired, and if a next step for a material is the manipulator executing the pick-up task, the found material is added to a material list. For the Scenario 4, the materials in a material list include the Material 10, the Material 11, and the Material 12.

If there is no material in a material list of a group, the search of the group is ended; and if there are materials in the material list of the group, a material with the minimum material ID in the material list is determined. For the Scenario 4, the Material 10 is the material with the minimum material ID that is found.

It is determined whether a module where the material with the minimum material ID is currently located is in the idle state; if the module where the material with the minimum material ID is currently located is not in the idle state, the search of the group is ended; if the module where the material with the minimum material ID is currently located is in the idle state, it is determined whether to follow the customized pick-up rule; and if not following the customized pick-up rule, it is determined that the pick-up task can be executed for the material with the minimum material ID in the group. If following the customized pick-up rule, it is determined whether executing the pick-up task for the material with the minimum material ID in the group meets the customized pick-up rule; if the customized pick-up rule is not met, the search of the group is ended; and if the customized pick-up rule is met, it is determined that the pick-up task can be executed for the material with the minimum material ID in the group. If a material capable of being subjected to the pick-up task is not found in any group, it is determined that the manipulator is not to execute the pick-up task.

In a case where the customized pick-up rule is that after the manipulator picks up a material, a module where the material needs to arrive at a next step needs to have an idle slot for placement of the material, in the Scenario 4, if the module where the Material 10 needs to arrive at a next step is Process Chamber 1, all the process chambers are searched; if a certain process chamber has an idle slot for the placement of the material, the Material 10 can be picked up by the vacuum manipulator; and if all the process chambers are occupied, the customized pick-up rule is not met, so that the Material 10 cannot be picked up from the LA by the vacuum manipulator.

In an embodiment, the exchange task corresponding to the manipulator includes a first exchange task that is to first pick and then put. The step of determining whether the specified tasks corresponding to the modules are executable based on the preset rules and the module information corresponding to the modules may include the following sub-steps S51 to S53.

At sub-step S51, based on the judgment rule for determining whether the manipulator executes the first exchange task, if it is determined, according to the module information corresponding to the manipulator, that the manipulator is in the idle state, and the manipulator has a material on one arm and has no material on another arm, it is determined whether a first candidate material which needs the manipulator to execute the pick-up task exists among all materials of the modules where the material on the manipulator needs to arrive at a next step.

At sub-step S52, in a case where the preset rules do not include the material first-in first-out rule, if it is determined that a first target material meeting a third preset condition exists in the first candidate material, it is determined that the manipulator can execute the first exchange task; and the third preset condition is that a module where a material is located is in the idle state, and the preset rules do not include a customized pick-up rule; or, in a case where the preset rules include the customized pick-up rule, a module to which the manipulator needs to move a material at a next step needs to meet the customized pick-up rule.

At sub-step S53, in a case where the preset rules include the material first-in first-out rule, if a material with the minimum material ID in the first candidate material meets a fourth preset condition, it is determined that the manipulator can execute the first exchange task; and the fourth preset condition is that a module where a material with the minimum material ID is located is in the idle state, and the preset rules do not include a customized pick-up rule; or, in a case where the preset rules include the customized pick-up rule, a module to which the manipulator needs to move a material at a next step needs to meet the customized pick-up rule.

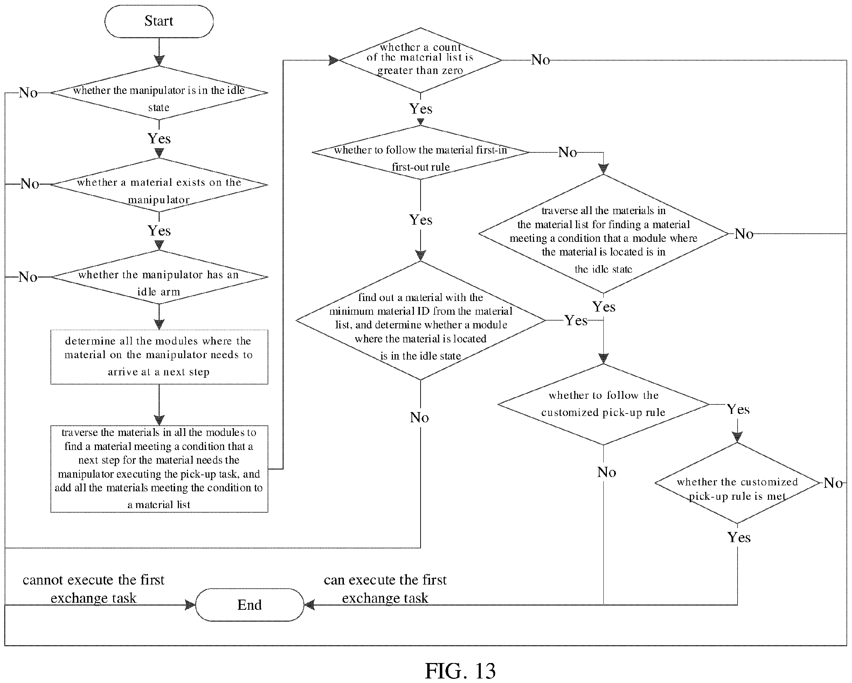

FIG. 13 is a flowchart of determining whether a manipulator can execute a first exchange task based on the preset rules according to an embodiment of the present disclosure. Referring to FIG. 13, it is first determined whether the manipulator is in the idle state, and if the manipulator is not in the idle state, it is determined that the manipulator cannot execute the first exchange task; if the manipulator is in the idle state, it is determined whether a material exists on the manipulator; if there is no material on the manipulator, it is determined that the manipulator cannot execute the first exchange task; if the material exists on the manipulator, it is determining whether the manipulator has an idle arm; if the manipulator has no idle arm, it is determined that the manipulator cannot execute the first exchange task; if the manipulator has the idle arm, all the modules where the material on the manipulator needs to arrive at a next step are determined, the materials in all the modules are traversed to find a material meeting a condition that a next step for the material needs the manipulator executing the pick-up task, and the found material meeting the condition is added to a material list; it is determined whether a count of the material list is greater than zero, and if the count is not greater than zero, it is determined that the manipulator cannot execute the first exchange task; and if the count is greater than zero, it is determined whether to follow the material first-in first-out rule.

If not following the material first-in first-out rule, all the materials in the material list are traversed for finding a material meeting a condition that a module where the material is located is in the idle state; if the material meeting the condition is not found, it is determined that the manipulator cannot execute the first exchange task; if the material meeting the condition is found, it is determined whether to follow a customized pick-up rule; if not following the customized pick-up rule, it is determined that the manipulator can execute the first exchange task (that is, the manipulator first executes the pick-up task for the material found from the material list, and then executes the placement task for the material on the manipulator); if following the customized pick-up rule, it is determined whether executing the pick-up task for the material found from the material list meets the customized pick-up rule; if the customized pick-up rule is not met, it is determined that the manipulator cannot execute the first exchange task; and if the customized pick-up rule is met, it is determined that the manipulator can execute the first exchange task.

If following the material first-in first-out rule, a material with the minimum material ID in the material list is determined, and it is determined whether a module where the material is located is in the idle state; if the module where the material is located is not in the idle state, it is determined that the manipulator cannot execute the first exchange task; if the module where the material is located is in the idle state, it is determined whether to follow a customized pick-up rule; if not following the customized pick-up rule, it is determined that the manipulator can execute the first exchange task (that is, the manipulator first executes the pick-up task for the material with the minimum material ID in the material list, and then executes the placement task for the material on the manipulator); if following the customized pick-up rule, it is determined whether executing the pick-up task for the material with the minimum material ID in the material list meets the customized pick-up rule; if the customized pick-up rule is not met, it is determined that the manipulator cannot execute the first exchange task; and if the customized pick-up rule is met, it is determined that the manipulator can execute the first exchange task.

Assuming that there is Scenario 5 as follows:
the vacuum manipulator is in the idle state, and has the following material existence situations: Material 10 (which needs to arrive at a process chamber at a next step) exists on one arm, and no material exists on another arm.

Material existence situations of all the process chambers where the material on the vacuum manipulator needs to arrive at the next step are as follows:
Process Chamber 1: Material 5 (with an ID of 5), which has been processed;
Process Chamber 2: Material 4 (with an ID of 4), which has been processed;
Process Chamber 3: Material 6 (with an ID of 6), which is being processed;
Process Chamber 4: Material 7 (with an ID of 7), which is being processed;
Process Chamber 5: no material; and
Process Chamber 6: no material.

Based on the preset rules, the modules where the material on the vacuum manipulator needs to arrive at the next step are all the process chambers in the Scenario 5.

All the materials in all the process chambers where the material on the vacuum manipulator needs to arrive at the next step are found, and if a next step for a material is the vacuum manipulator executing the pick-up task, the material is added to a material list. In the Scenario 5, the Material 5, the Material 4, the Material 6, and the Material 7 are added to a material list.

If not following the material first-in first-out rule, all the materials in the material list are traversed. In a case of finding a material meeting the following condition: a module where the material is located is in the idle state, and there is no need to perform determination according to the customized pick-up rule, or the customized pick-up rule is met in a case where there is a need to perform determination according to the customized pick-up rule, the first exchange task is executable. For the Scenario 5, it may be found that the Material 5 in the process chamber and the material on the vacuum manipulator can be subjected to the first exchange task.

If following the material first-in first-out rule, a material with the minimum material ID is found from the material list; and if a module where the material with the minimum material ID is located is not in the busy state, and the customized pick-up rule is met or the customized pick-up rule is not needed, the first exchange task of the vacuum manipulator is executable. For the Scenario 5, a material with the minimum material ID that is found is the Material 4, and the module where the Material 4 is located is in the idle state, so that the Material 4 in the Process Chamber 2 and the material on the vacuum manipulator can be subjected to the first exchange task.

In an embodiment, the exchange task corresponding to the manipulator includes a second exchange task that is to first put and then pick. The step of determining whether the specified tasks corresponding to the modules are executable based on the preset rules and the module information corresponding to the modules may include the following sub-steps S54 to S56.

At sub-step S54, based on the judgment rule for determining whether the manipulator executes the second exchange task, if it is determined, according to the module information corresponding to the manipulator, that the manipulator is in the idle state, and the manipulator has a material thereon, it is determined whether a second candidate material which needs the manipulator to execute the pick-up task exists among all materials of the modules where the material on the manipulator needs to arrive at a next step.

At sub-step S55, in a case where the preset rules do not include the material first-in first-out rule, if it is determined that a second target material meeting a fifth preset condition exists in the second candidate material, it is determined that the manipulator can execute the second exchange task; and the fifth preset condition is that a module where the second candidate material is located is in the idle state and has an idle slot, and the preset rules do not include a customized pick-up rule, or in a case where the preset rules include the customized pick-up rule, the manipulator executing the pick-up task for the second candidate material needs to meet the customized pick-up rule.

At sub-step S56, in a case where the preset rules include the material first-in first-out rule, if a material with the minimum material ID in the second candidate material meets a sixth preset condition, it is determined that the manipulator can execute the second exchange task; and the sixth preset condition is that a module where a material is located is in the idle state and has an idle slot, and the preset rules do not include a customized pick-up rule, or in a case where the preset rules include the customized pick-up rule, the manipulator executing the pick-up task for the material needs to meet the customized pick-up rule.

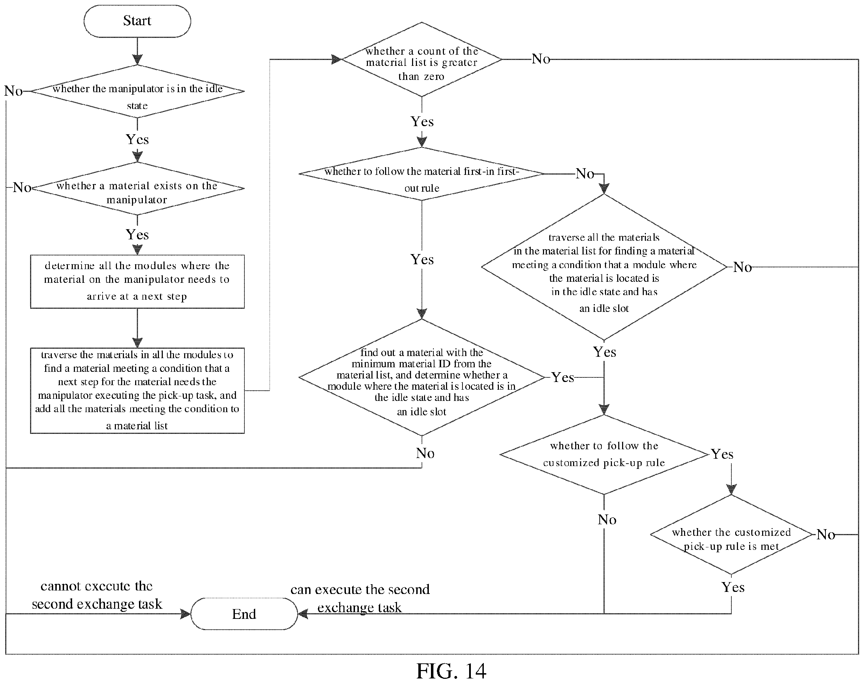

FIG. 14 is a flowchart of determining whether a manipulator can execute a second exchange task based on the preset rules according to an embodiment of the present disclosure. Referring to FIG. 14, it is first determined whether the manipulator is in the idle state, and if the manipulator is not in the idle state, it is determined that the manipulator cannot execute the second exchange task; if the manipulator is in the idle state, it is determined whether a material exists on the manipulator; if there is no material on the manipulator, it is determined that the manipulator cannot execute the second exchange task; if the material exists on the manipulator, all the modules where the material on the manipulator needs to arrive at a next step are determined; the materials in all the modules are traversed to find a material meeting a condition that a next step for the material needs the manipulator executing the pick-up task, and the found material meeting the condition is added to a material list; it is determined whether a count of the material list is greater than zero, and if the count is not greater than zero, it is determined that the manipulator cannot execute the second exchange task; and if the count is greater than zero, it is determined whether to follow the material first-in first-out rule.

If not following the material first-in first-out rule, all the materials in the material list are traversed for finding a material meeting a condition that a module where the material is located is in the idle state and has an idle slot; if the material meeting the condition is not found, it is determined that the manipulator cannot execute the second exchange task; if the material meeting the condition is found, it is determined whether to follow a customized pick-up rule; if not following the customized pick-up rule, it is determined that the manipulator can execute the second exchange task (that is, the manipulator executes the placement task for the material on the manipulator to place the material to the module where the material needs to arrive at the next step, and executes the pick-up task for a material in the module where the material needs to arrive at the next step); if following the customized pick-up rule, it is determined whether executing the pick-up task for the material found from the material list meets the customized pick-up rule; if the customized pick-up rule is not met, it is determined that the manipulator cannot execute the second exchange task; and if the customized pick-up rule is met, it is determined that the manipulator can execute the second exchange task.

If following the material first-in first-out rule, a material with the minimum material ID in the material list is determined, and it is determined whether a module where the material is located is in the idle state and has an idle slot; if the module where the material is located do not meet the condition of being in the idle state and having an idle slot, it is determined that the manipulator cannot execute the second exchange task; if the module where the material is located is in the idle state and has the idle slot, it is determined whether to follow a customized pick-up rule; if not following the customized pick-up rule, it is determined that the manipulator can execute the second exchange task (that is, the manipulator executes the placement task for the material on the manipulator to place the material to the module where the material needs to arrive at the next step, and executes the pick-up task for a material with the minimum material ID in the module where the material needs to arrive at the next step); if following the customized pick-up rule, it is determined whether executing the pick-up task for the material with the minimum material ID in the module where the material needs to arrive at the next step meets the customized pick-up rule; if the customized pick-up rule is not met, it is determined that the manipulator cannot execute the second exchange task; and if the customized pick-up rule is met, it is determined that the manipulator can execute the second exchange task.

Assuming that there is Scenario 6 as follows:
the atmospheric manipulator is in the idle state, and Material 13 (with an ID of 13) exists on the atmospheric manipulator and needs to enter a pre-pumping chamber.

Material existence situations of the pre-pumping chambers are as follows:
LA: Material 10 (with an ID of 10) exists and needs to enter a process chamber, and Material 3 (with an ID of 3) exists and needs to be returned to a loading and unloading module which is in the busy state;
LB: Material 2 (with an ID of 2) exists and needs to be returned to a loading and unloading module which is in the idle state and has an idle slot;
LC: Material 11 (with an ID of 11) exists and needs to enter a process chamber, Material 12 (with an ID of 12) exists and needs to enter a process chamber, and the process chambers are in the idle state; and
LD: Material 1(with an ID of 1) exists and needs to be returned to a loading and unloading module which is in the idle state.

Based on the preset rules:
in the Scenario 6, the atmospheric manipulator is in the idle state and has the material thereon, and it is found that the Material 13 on the atmospheric manipulator needs to enter a pre-pumping chamber; all the materials in all the pre-pumping chambers are traversed for finding a material meeting the following condition: a next step for the material is being picked up by the atmospheric manipulator; and the material meeting the condition is added to a material list. For the Scenario 6, all the materials that need to be picked up by the atmospheric manipulator at next steps are the Material 3, the Material 2, and the Material 1.

If not following the material first-in first-out rule, only a material meeting the following condition needs to be found: a module where the material is located is in the idle state and has an idle slot for placement of the material by the atmospheric manipulator, and there is no need to perform determination according to a customized pick-up rule, or the customized pick-up rule is met in a case where there is a need to perform determination according to the customized pick-up rule, the second exchange task is executable. For the Scenario 6, it may be found that the Material 2 in LB and the material on the atmospheric manipulator can be subjected to the second exchange task.

If following the material first-in first-out rule, a material with the minimum material ID is first found from the material list; and if a module where the material with the minimum material ID is located is in the idle state and has an idle slot for placement of the material by the atmospheric manipulator, and there is no need to perform determination according to a customized pick-up rule, or the customized pick-up rule is met in a case where there is a need to perform determination according to the customized pick-up rule, the second exchange task is executable. For the Scenario 6, it may be found that the Material 1 in LD and the material on the atmospheric manipulator can be subjected to the second exchange task.

At step 202, when it is determined that the specified tasks corresponding to the modules are executable, the modules are controlled to execute the corresponding specified tasks.

At step 203, before the modules start to execute the corresponding specified tasks, the module state information of the modules is set to be a busy state.

Before the modules start to execute the corresponding specified tasks, the module state information corresponding to the modules is updated from an idle state to the busy state.

At step 204, after the modules complete the corresponding specified tasks, the module state information of the modules is set to be the idle state.

After the modules complete the corresponding specified tasks, the module state information corresponding to the modules is updated from the busy state to the idle state.

At step 205, after the placement task for a material by the manipulator is completed, the material existence information corresponding to the manipulator is set to be "no material", and the material existence information corresponding to a module where the material is currently located is set to be "with material".

The placement task executed by the manipulator is to place the material which is on the manipulator to the module where the material needs to arrive at a next step. After the placement task is completed, the material existence information corresponding to the manipulator is updated from "with material" to "no material", and the material existence information corresponding to the module where the material is currently located is updated from "no material" to "with material".

At step 206, after the pick-up task for a material by the manipulator is completed, the material existence information corresponding to a module where the material is originally located is set to be "no material", and the material existence information corresponding to the manipulator is set to be "with material".

The pick-up task executed by the manipulator is to pick up the material by the manipulator from the module. After the pick-up task is completed, the material existence information corresponding to the module where the material is originally located is updated from "with material" to "no material", and the material existence information corresponding to the manipulator is updated from "no material" to "with material".

In an embodiment, the method may further include: after the process task for a material is completed in the process chamber, setting a state corresponding to the material to a processed state.

After the process task for the material is completed in the process chamber, a process-chamber process state corresponding to the material is updated from an unprocessed state to the processed state.

In an embodiment, the method may further include: after the process task for a material is completed in the cooling module, setting a state corresponding to the material to the processed state.

After the process task for the material is completed in the cooling module, a cooling-module process state corresponding to the material is updated from the unprocessed state to the processed state.

In an embodiment, the method may further include: after the pre-pumping chamber completes the vent task, setting the pre-pumping chamber to be in the atmospheric environment.

After the pre-pumping chamber completes the vent task, a state of the pre-pumping chamber is updated from the vacuum environment to the atmospheric environment.

In an embodiment, the method may further include: after the pre-pumping chamber completes the pump task, setting the pre-pumping chamber to be in the vacuum environment.

After the pre-pumping chamber completes the pump task, the state of the pre-pumping chamber is updated from the atmospheric environment to the vacuum environment.

In an embodiment, the method may further include: after the alignment task for a material is completed in the alignment module, setting a state corresponding to the material to an aligned state.

After the alignment task for the material is completed in the alignment module, the state corresponding to the material is updated from an unaligned state to the aligned state.

According to the embodiments of the present disclosure, for the process chamber, the pre-pumping chamber, the cooling module, the manipulator, and the alignment module of the semiconductor process apparatus, the module information corresponding to the modules is acquired one module by one module, and whether the specified tasks corresponding to the modules are executable is determined based on the preset rules configured to determine whether the modules execute the corresponding specified tasks and the module state information and the material existence information corresponding to the modules; and if it is determined that the specified tasks corresponding to the modules are executable, the modules are controlled to execute the corresponding specified tasks. The module state information is updated before the modules start to execute the corresponding specified tasks and after the modules complete the corresponding specified tasks. After the placement task and the pick-up task for the materials are completed by the manipulator, the material existence information of the corresponding modules is updated.

According to the embodiments of the present disclosure, instead of relying on the manually set execution time of the action task of each module, whether the specified tasks are executable is determined according to the current real-time module state information and the current real-time material existence information of the modules, so that the influence of inaccuracy of the manually set parameters is reduced; and a simple algorithm is adopted, the tasks executable by the modules can be quickly determined, idle time of each module for waiting for the tasks can be reduced, utilization of each module can be improved, and the equipment production capacity can be increased.

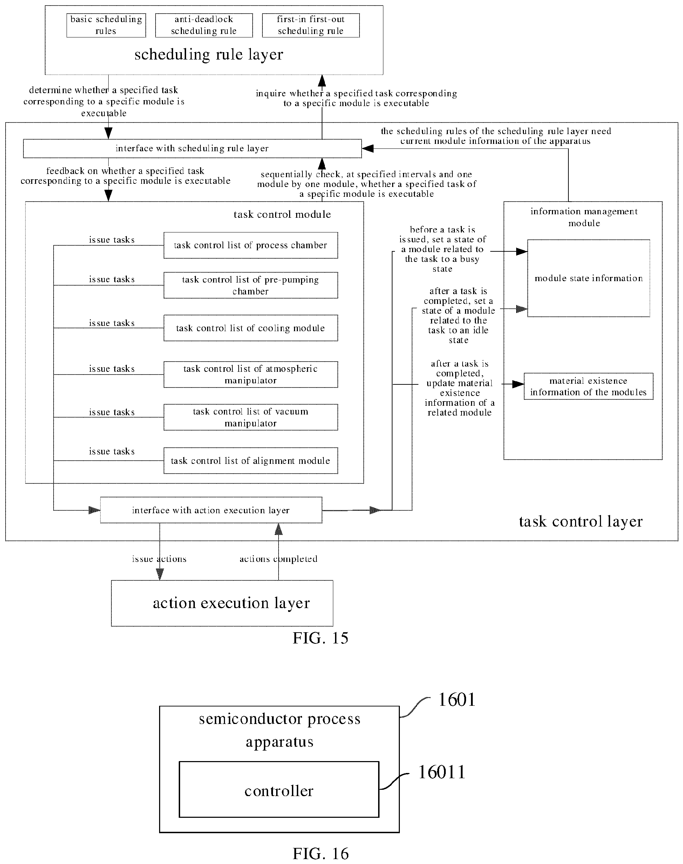

In order to enable those of ordinary skill in the art to better understand implementation processes of the embodiments of the present disclosure, the embodiments of the present disclosure are further illustrated below by an example. FIG. 15 is a structural diagram of a material scheduling control system according to an embodiment of the present disclosure.

The material scheduling control system may include: a scheduling rule layer, a task control layer, and an action execution layer.

The scheduling rule layer is provided with preset scheduling rules including the basic scheduling rules, the customized pick-up rules, the material first-in first-out rule, etc. The scheduling rule layer may determine whether the specified task corresponding to each module is executable according to the preset scheduling rules.

The task control layer includes a task control module, an information management module, an interface with the scheduling rule layer, and an interface with the action execution layer.

The task control module has the following functions.

Function 1: according to the types of the modules, find out all the modules capable of independently executing the tasks and all the manipulators. The manipulators may include the atmospheric manipulator and the vacuum manipulator, and need to execute the tasks which cannot be independently executed, such as the pick-up task, the placement task, and the exchange task. The modules capable of independently executing the tasks include: the process chamber (capable of independently executing the process task), the cooling module (capable of independently executing the process task), a pre-pumping chamber (capable of independently executing the vent task and the pump task), and the alignment module (capable of independently executing the alignment task).

Function 2: sequentially inquire the scheduling rule layer whether the specified tasks of the modules are executable. For example, for an etching device, it is necessary to sequentially inquire whether the process task of each process chamber is executable, whether the process task of each cooling module is executable, whether the vent task or the pump task of each pre-pumping chamber is executable, whether the alignment task of each alignment module is executable, and whether the pick-up task, the placement task, or the exchange task of each manipulator is executable.

Function 3: receive feedback information about whether the tasks are executable from the interface with the scheduling rule layer, and issue the tasks to the interface with the action execution layer if the tasks are executable.

The information management module is mainly configured to provide required real-time data for the scheduling rule layer.

Function 1: before a task of a module is started, set the module to be in the busy state;

Function 2: after a task of a module is completed, set the module to be in the idle state;

Function 3: after the pick-up task or the placement task is completed, update the material existence information of a corresponding module;

Function 4: after the vent task or the pump task is completed, update the pre-pumping chamber to be in the atmospheric environment or the vacuum environment;

Function 5: after a process task is completed, update a process state of a material to the processed state; and

Function 6: after the alignment task is completed, update a material to be in the aligned state.

The interface with the action execution layer has the following functions.
Function 1: after receiving the specified tasks corresponding to the modules, decompose the tasks into actions of components in the modules, and inform the information management module to respond to the beginning of the tasks of the modules while issuing the actions to the action execution layer;
Function 2: after receiving action execution complete instructions, detect whether all the decomposition actions of the tasks are completed, and inform the information management module to update the information if all the actions are completed.

The interface with the scheduling rule layer is mainly configured to realize interaction with the scheduling rule layer and has the following functions.
Function 1: receive task inquiries from the task control module, and send the task inquiries to the scheduling rule layer;
Function 2: acquire all the module information from the information management module, and transmit the module information to the scheduling rule layer while inquiring the scheduling rule layer whether the tasks are executable; and
Function 3: receive the information fed back from the scheduling rule layer about whether the tasks are executable, and inform the task control module of the received information.

The action execution layer is configured to receive action instructions from the task control layer, execute the corresponding actions, and provide feedback for the task control layer after execution of the actions is completed.

It should be noted that each method embodiment is described as a combination of a series of actions for simplifying the description, but it should be understood by those of ordinary skill in the art that the embodiments of the present disclosure are not limited to the described orders of the actions because some steps according to the embodiments of the present disclosure may be performed in other orders or may be performed simultaneously. Further, it should be further understood by those of ordinary skill in the art that the embodiments described in the specification are exemplary embodiments and the actions therein are not necessarily required by the embodiments of the present disclosure.

FIG. 16 is a block diagram of a semiconductor processing apparatus according to an embodiment of the present disclosure. Referring to FIG. 16, a semiconductor processing apparatus 1601 includes a plurality of modules that are configured with corresponding specified tasks, and further includes:
a controller 16011, which is configured to, for the plurality of modules, acquire module information corresponding to the modules one module by one module, and determine whether the specified tasks corresponding to the modules are executable based on preset rules and module information corresponding to the modules, with the module information including module state information and material existence information, and the preset rules including rules for determining whether the modules execute the corresponding specified tasks; and if it is determined that the specified tasks corresponding to the modules are executable, control the modules to execute the corresponding specified tasks.

According to the embodiment of the present disclosure, the module information corresponding to the modules is acquired one module by one module, and whether the specified tasks corresponding to the modules are executable is determined based on the preset rules configured to determine whether the modules execute the corresponding specified tasks and the module state information and the material existence information corresponding to the modules; and if it is determined that the specified tasks corresponding to the modules are executable, the modules are controlled to execute the corresponding specified tasks. According to the embodiment of the present disclosure, instead of relying on the manually set execution time of the action task of each module, whether the specified tasks are executable is determined according to the current real-time module state information and the current real-time material existence information of the modules, so that the influence of inaccuracy of the manually set parameters is reduced; and a simple algorithm is adopted, the tasks executable by the modules can be quickly determined, idle time of each module for waiting for the tasks can be reduced, utilization of each module can be improved, and the equipment production capacity can be increased.

In an alternative embodiment of the present disclosure, the plurality of modules may include: a process chamber, a pre-pumping chamber, a cooling module, a manipulator, and an alignment module.

The preset rules include: a judgment rule for determining whether the process chamber executes a process task; judgment rules for determining whether the pre-pumping chamber executes a vent task and a pump task; a judgment rule for determining whether the cooling module executes a process task; a judgment rule for determining whether the alignment module executes an alignment task; and judgment rules for determining whether the manipulator executes a pick-up task, a placement task, and an exchange task.

In an alternative embodiment of the present disclosure, the controller is configured to, based on the judgment rule for determining whether the process chamber executes the process task, if it is determined, according to the module information corresponding to the process chamber, that the process chamber is in an idle state, a material exists in the process chamber, and the material is not subjected to the process task in the process chamber, determine that the process chamber can execute the process task.

In an alternative embodiment of the present disclosure, the controller is configured to, based on the judgment rule for determining whether the cooling module executes the process task, if it is determined, according to the module information corresponding to the cooling module, that the cooling module is in an idle state, a material exists in the cooling module, and the material is not subjected to the process task in the cooling module, determine that the cooling module can execute the process task.

In an alternative embodiment of the present disclosure, the manipulator includes an atmospheric manipulator, and the controller is configured to, based on the judgment rule for determining whether the pre-pumping chamber executes the vent task, if it is determined, according to the module information corresponding to the pre-pumping chamber, that there is a pre-pumping chamber which is in an idle state and is not in an atmospheric environment, determine whether a material exists in the pre-pumping chamber; if the material exists in the pre-pumping chamber and a next step for the material is the atmospheric manipulator picking up the material and placing the material into an atmospheric end, determine that the pre-pumping chamber can execute the vent task; and if there is no material in the pre-pumping chamber and the number of materials to be placed by the atmospheric manipulator into pre-pumping chambers is less than the number of pre-pumping chambers that are in the atmospheric environment, determine that the pre-pumping chamber can execute the vent task.

In an alternative embodiment of the present disclosure, the manipulator includes a vacuum manipulator, and the controller is configured to, based on the judgment rule for determining whether the pre-pumping chamber executes the pump task, if it is determined, according to the module information corresponding to the pre-pumping chamber, that there is a pre-pumping chamber which is in an idle state and is not in a vacuum environment, determine whether a material exists in the pre-pumping chamber; if the material exists in the pre-pumping chamber and a next step for the material is the vacuum manipulator picking up the material and placing the material into a vacuum end, determine that the pre-pumping chamber can execute the pump task; and if there is no material in the pre-pumping chamber and the number of materials to be placed by the vacuum manipulator into pre-pumping chambers is less than the number of pre-pumping chambers that are in the vacuum environment, determine that the pre-pumping chamber can execute the pump task.

In an alternative embodiment of the present disclosure, the controller is configured to, based on the judgment rule for determining whether the alignment module executes the alignment task, if it is determined, according to the module information corresponding to the alignment module, that the alignment module is in an idle state and materials not subjected to the alignment task exist in the alignment module, determine that the alignment module can execute the alignment task.

In an alternative embodiment of the present disclosure, the controller is configured to, in a case where the preset rules further include a material first-in first-out rule, based on the judgment rule for determining whether the manipulator executes the placement task, if it is determined, according to the module information corresponding to the manipulator, that the manipulator is in the idle state and materials exist on the manipulator, group the materials on the manipulator according to the modules where the materials need to arrive at next steps; sequentially determine material IDs of the materials in each group, and determine a material with the minimum material ID in each group, with the material IDs being set for the materials based on the material first-in first-out rule; if a module where a material with the minimum material ID in a group needs to arrive at a next step is in the idle state and has an idle slot, determine that the manipulator can execute the placement task for the material with the minimum material ID in the group; and if there is no material to be subjected to the placement task in any group, determine that the manipulator is not to execute the placement task.

In an alternative embodiment of the present disclosure, the controller is configured to, in a case where the preset rules do not include the material first-in first-out rule, based on the judgment rule for determining whether the manipulator executes the placement task, if it is determined, according to the module information corresponding to the manipulator, that the manipulator is in the idle state and materials exist on the manipulator, determine whether the modules where the materials need to arrive at next steps are in the idle state and have idle slots; if the modules where the materials need to arrive at the next steps meet a condition of being in the idle state and having the idle slots, determine that the manipulator can execute the placement task for the materials; and if the modules where the materials need to arrive at the next steps do not meet the condition of being in the idle state and having the idle slots, determine that the manipulator cannot execute the placement task for the materials.

In an alternative embodiment of the present disclosure, the controller is configured to, in a case where the preset rules do not include the material first-in first-out rule, based on the judgment rule for determining whether the manipulator executes the pick-up task, if it is determined, according to the module information corresponding to the manipulator, that the manipulator is in the idle state and has an idle arm, determine whether a target module meeting a first preset condition exists among all the modules reachable by the manipulator, with the first preset condition being that a module is in the idle state, a material exists in the module, and a next step for the material is the manipulator executing the pick-up task, and the preset rules not including a customized pick-up rule, or in a case where the preset rules include the customized pick-up rule, picking up the material by the manipulator to the needed module at the next step meeting the customized pick-up rule; and if the target module exists, determine that the manipulator can execute the pick-up task for the material in the target module.

In an alternative embodiment of the present disclosure, the controller is configured to, in a case where the preset rules further include the material first-in first-out rule, based on the judgment rule for determining whether the manipulator can execute the pick-up task, if it is determined, according to the module information corresponding to the manipulator, that the manipulator is in the idle state and has an idle arm, group all the modules reachable by the manipulator according to types of the modules; sequentially determine whether a material to be subjected to the pick-up task exists in each group; if a material to be subjected to the pick-up task exists in a group and a material with the minimum material ID in the group meets a second preset condition, determine that the manipulator can execute the pick-up task for the material with the minimum material ID, with the second preset condition being that a module where a material is currently located is in the idle state, and the preset rules not including the customized pick-up rule, or in a case where the preset rules include the customized pick-up rule, picking up the material with the minimum material ID by the manipulator to a needed module at a next step meeting the customized pick-up rule; and if there is no material capable of being subjected to the pick-up task in any group, determine that the manipulator is not to execute the pick-up task.

In an alternative embodiment of the present disclosure, the exchange task corresponding to the manipulator includes a first exchange task that is to first pick and then put. The controller is configured to, based on the judgment rule for determining whether the manipulator executes the first exchange task, if it is determined, according to the module information corresponding to the manipulator, that the manipulator is in the idle state, and the manipulator has a material on one arm and has no material on another arm, determine whether a first candidate material which needs the manipulator to execute the pick-up task exists among all materials of the modules where the material on the manipulator needs to arrive at a next step; in a case where the preset rules do not include the material first-in first-out rule, if it is determined that a first target material meeting a third preset condition exists in the first candidate material, determine that the manipulator can execute the first exchange task, with the third preset condition being that a module where a material is located is in the idle state, and the preset rules not including a customized pick-up rule, or in a case where the preset rules include the customized pick-up rule, a module to which the manipulator needs to move a material at a next step meeting the customized pick-up rule; and in a case where the preset rules include the material first-in first-out rule, if a material with the minimum material ID in the first candidate material meets a fourth preset condition, determine that the manipulator can execute the first exchange task, with the fourth preset condition being that a module where a material with the minimum material ID is located is in the idle state, and the preset rules not including a customized pick-up rule, or in a case where the preset rules include the customized pick-up rule, a module to which the manipulator needs to move a material at a next step meeting the customized pick-up rule.

In an alternative embodiment of the present disclosure, the exchange task corresponding to the manipulator includes a second exchange task that is to first put and then pick. The controller is configured to, based on the judgment rule for determining whether the manipulator executes the second exchange task, if it is determined, according to the module information corresponding to the manipulator, that the manipulator is in the idle state and the manipulator has a material thereon, determine whether a second candidate material which needs the manipulator to execute the pick-up task exists among all materials of the modules where the material on the manipulator needs to arrive at a next step; in a case where the preset rules do not include the material first-in first-out rule, if it is determined that a second target material meeting a fifth preset condition exists in the second candidate material, determine that the manipulator can execute the second exchange task, with the fifth preset condition being that a module where the second candidate material is located is in the idle state and has an idle slot, and the preset rules not including a customized pick-up rule, or in a case where the preset rules include the customized pick-up rule, the manipulator executing the pick-up task for the second candidate material meeting the customized pick-up rule; and in a case where the preset rules include the material first-in first-out rule, if a material with the minimum material ID in the second candidate material meets a sixth preset condition, determine that the manipulator can execute the second exchange task, with the sixth preset condition being that a module where a material is located is in the idle state and has an idle slot, and the preset rules not including a customized pick-up rule, or in a case where the preset rules include the customized pick-up rule, the manipulator executing the pick-up task for the material meeting the customized pick-up rule.

In an alternative embodiment of the present disclosure, the controller is further configured to, before the modules start to execute the corresponding specified tasks, set the module state information of the modules to be a busy state; after the modules complete the corresponding specified tasks, set the module state information of the modules to be the idle state; after the placement task for a material by the manipulator is completed, set the material existence information corresponding to the manipulator to be "no material", and set the material existence information corresponding to a module where the material is currently located to be "with material"; and after the pick-up task for a material by the manipulator is completed, set the material existence information corresponding to a module where the material is originally located to be "no material", and set the material existence information corresponding to the manipulator to be "with material".

In an alternative embodiment of the present disclosure, the controller is further configured to set, after the process task for a material is completed in the process chamber, a state corresponding to the material to a processed state.

In an alternative embodiment of the present disclosure, the controller is further configured to set, after the process task for a material is completed in the cooling module, a state corresponding to the material to the processed state.

In an alternative embodiment of the present disclosure, the controller is further configured to set, after the pre-pumping chamber completes the vent task, the pre-pumping chamber to be in the atmospheric environment.

In an alternative embodiment of the present disclosure, the controller is further configured to set, after the pre-pumping chamber completes the pump task, the pre-pumping chamber to be in the vacuum environment.

In an alternative embodiment of the present disclosure, the controller is further configured to set, after the alignment task for a material is completed in the alignment module, a state corresponding to the material to an aligned state.

The embodiments in the present specification are all described in a progressive manner, and each embodiment focuses on the differences from the other embodiments; and for the same or similar contents of the embodiments, reference may be made to each other.

It should be understood by those of ordinary skill in the art that the embodiments of the present disclosure may be implemented as a method, a device, or a computer program product. Accordingly, the embodiments of the present disclosure may take the form of embodiments involving hardware alone, embodiments involving software alone, or embodiments combining software and hardware. Furthermore, the embodiments of the present disclosure may take the form of a computer program product, which is implemented on one or more computer-usable storage media (including, but not limited to, magnetic disks, Compact Disc Read-Only Memories (CD-ROMs), and optical storage devices) containing computer-usable program codes.

The embodiments of the present disclosure are described with reference to the flowcharts and/or the block diagrams illustrating the method, the terminal device (system), and the computer program product according to the embodiments of the present disclosure. It should be understood that each process of the flowcharts and/or each block of the block diagrams, and a combination of processes of the flowcharts and/or a combination of the blocks of the block diagrams may be implemented by computer program instructions. The computer program instructions may be provided for a general purpose computer, a special purpose computer, an embedded processor, or processors of other programmable data processing terminal devices to produce a machine, such that the instructions executed by the computers or the processors of the other programmable data processing terminal devices can generate a device configured to perform a function or functions specified in one or more processes of the flowcharts and/or one or more blocks of the block diagrams.

The computer program instructions may also be stored in a computer-readable memory capable of guiding the computers or the other programmable data processing terminal devices to operate in a particular manner, such that the instructions stored in the computer-readable memory can produce a product including an instruction device configured to perform a function or functions specified in one or more processes of the flowcharts and/or one or more blocks of the block diagrams.

The computer program instructions may also be loaded to the computers or the other programmable data processing terminal devices, so as to cause the computers or the other programmable data processing terminal devices to perform a series of steps to produce the processing realized by the computers, such that the instructions executed on the computers or the other programmable terminal devices can provide steps for performing a function or functions specified in one or more processes of the flowcharts and/or one or more blocks of the block diagrams.

Although the preferred embodiments of the present disclosure are described, those of ordinary skill in the art can make other variations and modifications to the embodiments once they learn of the basic inventive concept. Therefore, the appended claims are intended to be interpreted as including the preferred embodiments and all the variations and modifications that fall within the scope of the embodiments of the present disclosure.

Finally, it should be further noted that the relational terms such as "first" and "second" herein are only used to distinguish one entity or action from another entity or action, and do not necessarily require or imply that such relationship or order actually exists between the entities or actions. Moreover, the terms "includes", "comprises" or any other variation thereof are intended to indicate a non-exclusive inclusion, so that a process, method, article, or terminal device, which includes a series of elements, does not only include those listed elements but also include other elements which are not explicitly listed, or the elements inherent in such process, method, article, or terminal device. If there are no more limitations, limiting an element by "including a (or one)..." does not exclude the existence of other identical elements in the process, method, article, or terminal device which includes the element.

The scheduling control method for a semiconductor process apparatus and the semiconductor process apparatus provided in the present disclosure are described in detail above. The principle and the implementations of the present disclosure are illustrated by specific examples, and the above description of the embodiments is only used to help understand the method and the core idea of the present disclosure. Meanwhile, those of ordinary skill in the art can make a change in the specific embodiments and the application range according to the idea of the present disclosure. In summary, the contents of the specification should not be interpreted as a limitation to the present disclosure.

## Claims

1. A scheduling control method for a semiconductor process apparatus, wherein the semiconductor process apparatus comprises a plurality of modules that are configured with corresponding specified tasks, and the method comprises:
for the plurality of modules, acquiring module information corresponding to the modules one module by one module, and determining whether the specified tasks corresponding to the modules are executable based on preset rules and the module information corresponding to the modules; the module information comprises module state information and material existence information; and the preset rules comprise rules for determining whether the modules execute the corresponding specified tasks; and
in response to determining that the specified tasks corresponding to the modules are executable, controlling the modules to execute the corresponding specified tasks.

2. The method of claim 1, wherein the plurality of modules comprise: a process chamber, a pre-pumping chamber, a cooling module, a manipulator, and an alignment module; and
the preset rules comprise: a judgment rule for determining whether the process chamber executes a process task; judgment rules for determining whether the pre-pumping chamber executes a vent task and a pump task; a judgment rule for determining whether the cooling module executes a process task; a judgment rule for determining whether the alignment module executes an alignment task; and judgment rules for determining whether the manipulator executes a pick-up task, a placement task, and an exchange task.

3. The method of claim 2, wherein determining whether the specified tasks corresponding to the modules are executable based on the preset rules and the module information corresponding to the modules comprises:
based on the judgment rule for determining whether the process chamber executes the process task, in response to determining, according to the module information corresponding to the process chamber, that the process chamber is in an idle state, a material exists in the process chamber, and the material is not subjected to the process task in the process chamber, determining that the process chamber is capable of executing the process task.

4. The method of claim 2, wherein determining whether the specified tasks corresponding to the modules are executable based on the preset rules and the module information corresponding to the modules comprises:
based on the judgment rule for determining whether the cooling module executes the process task, in response to determining, according to the module information corresponding to the cooling module, that the cooling module is in an idle state, a material exists in the cooling module, and the material is not subjected to the process task in the cooling module, determining that the cooling module is capable of executing the process task.

5. The method of claim 2, wherein the manipulator comprises an atmospheric manipulator, and determining whether the specified tasks corresponding to the modules are executable based on the preset rules and the module information corresponding to the modules comprises:
based on a judgment rule for determining whether the pre-pumping chamber executes the vent task, in response to determining, according to the module information corresponding to the pre-pumping chamber, that there is a pre-pumping chamber which is in an idle state and is not in an atmospheric environment, determining whether a material exists in the pre-pumping chamber;
in response to the material existing in the pre-pumping chamber and a next step for the material being the atmospheric manipulator picking up the material and placing the material into an atmospheric end, determining that the pre-pumping chamber is capable of executing the vent task; and
in response to no material existing in the pre-pumping chamber and a number of materials to be placed by the atmospheric manipulator into pre-pumping chambers being less than a number of pre-pumping chambers that are in the atmospheric environment, determining that the pre-pumping chamber is capable of executing the vent task.

6. The method of claim 2, wherein the manipulator comprises a vacuum manipulator, and determining whether the specified tasks corresponding to the modules are executable based on the preset rules and the module information corresponding to the modules comprises:
based on a judgment rule for determining whether the pre-pumping chamber executes the pump task, in response to determining, according to the module information corresponding to the pre-pumping chamber, that there is a pre-pumping chamber which is in an idle state and is not in a vacuum environment, determining whether a material exists in the pre-pumping chamber;
in response to the material existing in the pre-pumping chamber and a next step for the material being the vacuum manipulator picking up the material and placing the material into a vacuum end, determining that the pre-pumping chamber is capable of executing the pump task; and
in response to no material existing in the pre-pumping chamber and a number of materials to be placed by the vacuum manipulator into pre-pumping chambers being less than a number of pre-pumping chambers that are in the vacuum environment, determining that the pre-pumping chamber is capable of executing the pump task.

7. The method of claim 2, wherein determining whether the specified tasks corresponding to the modules are executable based on the preset rules and the module information corresponding to the modules comprises:
based on the judgment rule for determining whether the alignment module executes the alignment task, in response to determining, according to the module information corresponding to the alignment module, that the alignment module is in an idle state and materials not subjected to the alignment task exist in the alignment module, determining that the alignment module is capable of executing the alignment task.

8. The method of claim 2, wherein determining whether the specified tasks corresponding to the modules are executable based on the preset rules and the module information corresponding to the modules comprises:
in a case where the preset rules further comprise a material first-in first-out rule, based on a judgment rule for determining whether the manipulator executes the placement task, in response to determining, according to the module information corresponding to the manipulator, that the manipulator is in an idle state and materials exist on the manipulator, grouping the materials on the manipulator according to modules where the materials need to arrive at next steps;
sequentially determining material IDs of materials in each group, and determining a material with a minimum material ID in each group; and the material IDs are set for the materials based on the material first-in first-out rule;
in response to a module where a material with a minimum material ID in a group needs to arrive at a next step being in an idle state and having an idle slot, determining that the manipulator is capable of executing the placement task for the material with the minimum material ID in the group; and
in response to no material to be subjected to the placement task existing in any group, determining that the manipulator is not to execute the placement task.

9. The method of claim 8, wherein determining whether the specified tasks corresponding to the modules are executable based on the preset rules and the module information corresponding to the modules comprises:
in a case where the preset rules do not comprise the material first-in first-out rule, based on the judgment rule for determining whether the manipulator executes the placement task, in response to determining, according to the module information corresponding to the manipulator, that the manipulator is in the idle state and materials exist on the manipulator, determining whether modules where the materials need to arrive at next steps are in the idle state and have idle slots;
in response to the modules where the materials need to arrive at the next steps meeting a condition of being in the idle state and having the idle slots, determining that the manipulator is capable of executing the placement task for the materials; and
in response to the modules where the materials need to arrive at the next steps not meeting the condition of being in the idle state and having the idle slots, determining that the manipulator is not capable of executing the placement task for the materials.

10. The method of claim 2, wherein determining whether the specified tasks corresponding to the modules are executable based on the preset rules and the module information corresponding to the modules comprises:
in a case where the preset rules do not comprise a material first-in first-out rule, based on a judgment rule for determining whether the manipulator executes the pick-up task, in response to determining, according to the module information corresponding to the manipulator, that the manipulator is in an idle state and has an idle arm, determining whether a target module meeting a first preset condition exists among all modules reachable by the manipulator; and the first preset condition is that a module is in an idle state, a material exists in the module, and a next step for the material is the manipulator executing the pick-up task, and the preset rules do not comprise a customized pick-up rule, or in a case where the preset rules comprise the customized pick-up rule, picking up the material by the manipulator to a needed module at the next step meets the customized pick-up rule; and
in response to the target module existing, determining that the manipulator is capable of executing the pick-up task for a material in the target module.

11. The method of claim 10, wherein determining whether the specified tasks corresponding to the modules are executable based on the preset rules and the module information corresponding to the modules comprises:
in a case where the preset rules further comprise the material first-in first-out rule, based on the judgment rule for determining whether the manipulator executes the pick-up task, in response to determining, according to the module information corresponding to the manipulator, that the manipulator is in the idle state and has an idle arm, grouping all modules reachable by the manipulator according to types of the modules;
sequentially determining whether a material to be subjected to the pick-up task exists in each group;
in response to a material to be subjected to the pick-up task existing in a group and a material with a minimum material ID in the group meets a second preset condition, determining that the manipulator is capable of executing the pick-up task for the material with the minimum material ID; and the second preset condition is that a module where a material is currently located is in an idle state, and the preset rules do not comprise the customized pick-up rule; or, in a case where the preset rules comprise the customized pick-up rule, picking up the material with the minimum material ID by the manipulator to a needed module at a next step meets the customized pick-up rule; and
in response to no material capable of being subjected to the pick-up task existing in any group, determining that the manipulator is not to execute the pick-up task.

12. The method of claim 2, wherein the exchange task corresponding to the manipulator comprises a first exchange task that is to first pick and then put; and determining whether the specified tasks corresponding to the modules are executable based on the preset rules and the module information corresponding to the modules comprises:
based on a judgment rule for determining whether the manipulator executes the first exchange task, in response to determining, according to the module information corresponding to the manipulator, that the manipulator is in an idle state and the manipulator has a material on one arm and has no material on another arm, determining whether a first candidate material which needs the manipulator to execute a pick-up task exists among all materials of modules where the material on the manipulator needs to arrive at a next step;
in a case where the preset rules do not comprise a material first-in first-out rule, in response to determining that a first target material meeting a third preset condition exists in the first candidate material, determining that the manipulator is capable of executing the first exchange task; and the third preset condition is that a module where a material is located is in an idle state, and the preset rules do not comprise a customized pick-up rule; or, in a case where the preset rules comprise the customized pick-up rule, a module to which the manipulator needs to move a material at a next step needs to meet the customized pick-up rule; and
in a case where the preset rules comprise the material first-in first-out rule, in response to a material with a minimum material ID in the first candidate material meeting a fourth preset condition, determining that the manipulator is capable of executing the first exchange task; and the fourth preset condition is that a module where the material with the minimum material ID is located is in an idle state, and the preset rules do not comprise a customized pick-up rule; or, in a case where the preset rules comprise the customized pick-up rule, a module to which the manipulator needs to move a material at a next step needs to meet the customized pick-up rule.

13. The method of claim 12, wherein the exchange task corresponding to the manipulator further comprises a second exchange task that is to first put and then pick; and determining whether the specified tasks corresponding to the modules are executable based on the preset rules and the module information corresponding to the modules comprises:
based on a judgment rule for determining whether the manipulator executes the second exchange task, in response to determining, according to the module information corresponding to the manipulator, that the manipulator is in the idle state and the manipulator has a material thereon, determining whether a second candidate material which needs the manipulator to execute the pick-up task exists among all materials of modules where the material on the manipulator needs to arrive at a next step;
in a case where the preset rules do not comprise the material first-in first-out rule, in response to determining that a second target material meeting a fifth preset condition exists in the second candidate material, determining that the manipulator is capable of executing the second exchange task; and the fifth preset condition is that a module where the second candidate material is located is in the idle state and has an idle slot, and the preset rules do not comprise a customized pick-up rule; or, in a case where the preset rules comprise the customized pick-up rule, the manipulator executing the pick-up task for the second candidate material needs to meet the customized pick-up rule; and
in a case where the preset rules comprise the material first-in first-out rule, in response to a material with a minimum material ID in the second candidate material meeting a sixth preset condition, determining that the manipulator is capable of executing the second exchange task; and the sixth preset condition is that a module where a material is located is in the idle state and has an idle slot, and the preset rules do not comprise a customized pick-up rule; or, in a case where the preset rules comprise the customized pick-up rule, the manipulator executing the pick-up task for the material needs to meet the customized pick-up rule.

14. The method of claim 2, further comprising:
before the modules start to execute the corresponding specified tasks, setting the module state information of the modules to be a busy state;
after the modules complete the corresponding specified tasks, setting the module state information of the modules to be an idle state;
after the placement task for a material by the manipulator is completed, setting the material existence information corresponding to the manipulator to indicate no existence of material, and setting the material existence information corresponding to a module where the material is currently located to indicate existence of material; and
after the pick-up task for a material by the manipulator is completed, setting the material existence information corresponding to a module where the material is originally located to indicate no existence of material, and setting the material existence information corresponding to the manipulator to indicate existence of material.

15. The method of claim 3, further comprising:
after the process task for the material is completed in the process chamber, setting a state corresponding to the material to a processed state.

16. The method of claim 4, further comprising:
after the process task for the material is completed in the cooling module, setting a state corresponding to the material to a processed state.

17. The method of claim 5, further comprising:
after the pre-pumping chamber completes the vent task, setting the pre-pumping chamber to be in the atmospheric environment.

18. The method of claim 6, further comprising:
after the pre-pumping chamber completes the pump task, setting the pre-pumping chamber to be in the vacuum environment.

19. The method of claim 7, further comprising:
after the alignment task for the material is completed in the alignment module, setting a state corresponding to the material to an aligned state.

20. A semiconductor processing apparatus, comprising a plurality of modules that are configured with corresponding specified tasks, and further comprising:
a controller, which is configured to, for the plurality of modules, acquire module information corresponding to the modules one module by one module, and determine whether the specified tasks corresponding to the modules are executable based on preset rules and module information corresponding to the modules, with the module information comprising module state information and material existence information and the preset rules comprising rules for determining whether the modules execute the corresponding specified tasks; and in response to determining that the specified tasks corresponding to the modules are executable, control the modules to execute the corresponding specified tasks.
